(19) Europäisches Patentamt
European Patent Office
Office européen des brevets

(11) EP 1 584 984 A1

# (12) EUROPEAN PATENT APPLICATION

(43) Date of publication:
**12.10.2005 Bulletin 2005/41**

(51) Int Cl.[7]: **G03F 7/30**, B41C 1/10

(21) Application number: **05007523.3**

(22) Date of filing: **06.04.2005**

(84) Designated Contracting States:
**AT BE BG CH CY CZ DE DK EE ES FI FR GB GR HU IE IS IT LI LT LU MC NL PL PT RO SE SI SK TR**
Designated Extension States:
**AL BA HR LV MK YU**

(30) Priority: **06.04.2004 JP 2004112362**
**30.03.2005 JP 2005098664**

(71) Applicant: **FUJI PHOTO FILM CO., LTD.**
**Kanagawa (JP)**

(72) Inventor: **Takamiya, Shuichi**
**Haibara-gun Shizuoka (JP)**

(74) Representative: **HOFFMANN EITLE**
**Patent- und Rechtsanwälte**
**Arabellastrasse 4**
**81925 München (DE)**

## (54) Method for replenishing developer in an automatic developing machine for photosensitive lithographic printing plate

(57) The electric conductivity of the developer is measured in a constant cycle and after replenishing the aging replenishment amount setting value at constant time intervals and replenishing the processing replenishment amount setting value every each processing of plates in a fixed area by using a development replenisher containing an electric conductivity adjusting agent of elevating the electric conductivity, the electric conductivity calculated value is calculated from the aging replenishment amount and the processing replenishment amount and based on the results of comparison between the electric conductivity calculated value and the electric conductivity measured value, the values of aging replenishment amount setting value and processing replenishment amount setting value each is increased or decreased.



Printed by Jouve, 75001 PARIS (FR)

## Description

## Background of the Invention

1. Field of the Invention

The present invention relates to a method for replenishing a development replenisher in an automatic developing machine for photosensitive lithographic printing plates. More specifically, the present invention relates to a method for replenishing a development replenisher in an automatic developing machine for photosensitive lithographic printing plates, where fluctuation of the developer sensitivity particularly due to change in the processing conditions of development is minimized by using a development replenisher containing an electric conductivity adjusting agent of elevating the electric conductivity.

2. Description of the Related Art

In recent years, lasers are making a remarkable progress. Particularly, as for the solid laser and semiconductor laser having light emission region in the range from near infrared to infrared, lasers having high output and small size are now easily available. These lasers are very useful as an exposure light source in directly producing a printing plate based on digital data. With respect to an image recording material suitable for laser writing, for example, " JP-A-7-285275 (the term "JP-A" as used herein means an "unexamined published Japanese patent application")" has proposed a positive image recording material comprising a binder such as cresol resin, a substance of absorbing light and generating heat, and a thermally decomposable compound which can, in the state before decomposition, substantially decrease the solubility of the binder, such as quinonediazide. According to this technique, the substance of absorbing light and generating heat causes heat generation in the exposed portion after irradiation of near infrared light and renders the exposed portion alkali-soluble (heat-mode type), but the heat is absorbed by aluminum as the support to give low thermal efficiency, and the dissolution with an alkali developing solution at the development step is not satisfied. In order to ensure the dissolution of the exposed portion, the alkali concentration of the developer is elevated. However, under such a high alkali concentration condition, the heat-mode type lithographic printing plate precursor has a problem that the image part is low in the dissolution resistance against an alkali developing solution and is dissolved due to only slight scratching present on the image recording material surface to produce defects in the image part. This tendency is more outstanding particularly in the positive lithographic printing plate precursor using a polymer compound having high solubility in an aqueous alkali solution. In this way, the technique of elevating the alkali concentration of the alkali developer without causing residual film in the non-image part has limits, and a high-sharpness clear image free from defects in the formed image area can be hardly obtained. Particularly, in the case of a fine image including dot parts and thin lines, higher sharpness and enhanced reproducibility are demanded. To satisfy these requirements, in an automatic developing apparatus for photosensitive lithographic printing plates, there is employed a system of replenishing a development replenisher according to aging and processing, where a development replenisher is replenished in aging to a developing tank storing a developer and at the same time, by measuring the plate area of the lithographic printing plate processed, the development replenisher is replenished in an amount according to the measured value (hereinafter referred to as an "area aging-based replenishment system"), or a replenishment system of determining the deterioration of developer by measuring the electric conductivity, and then replenishing the replenisher according to the previously programmed instruction.

## Summary of the Invention

However, in such an area aging-based replenishment system, a high-precision device of measuring the plate area of a lithographic printing plate must be disposed in the developing unit of an automatic developing apparatus, and this disadvantageously incurs a complicated structure and a high cost. Also, it is difficult to discriminate whether only one surface or both surfaces (hereinafter referred to as "one surface/both surfaces") of the lithographic printing plate serve(s) as the photosensitive surface, or to determine the plate species (for example, a plate differing in the coated amount of photosensitive layer). Therefore, this system has a problem that when the replenishment amount of the development replenisher required as a result of change in the plate area·one surface/both surfaces·plate species of the lithographic printing plate, the development replenishing amount becomes difficult to properly replenish. In the system of determining the deterioration of developer by measuring the electric conductivity, and then replenishing the replenisher according to the previously programmed instruction, proper replenishment may not be performed due to increase in the replenishment amount and excessively high electric conductivity. Under these circumstances, an object of the present invention is to provide a method and an apparatus for automatically developing a photosensitive lithographic printing plate, which are used in developing an exposed photosensitive lithographic printing plate and in which

the developing unit of the automatic developing apparatus can be made to have a simple and inexpensive construction and at the same time, the fluctuation of developer sensitivity due to change in the processing conditions of development with a developer containing an electrolyte can be minimized by using a development replenisher containing an electric conductivity adjusting agent of elevating the electric conductivity.

The term "development replenisher" as used in the present invention means a processing solution replenished so as to keep constant the development performance. In general, the replenisher includes those obtained by diluting the replenisher stock solution with a diluent (e.g., water) and those using the replenisher stock solution as-is without diluting it. In the present invention, the "development replenisher" means a processing solution prepared by diluting the replenisher stock solution with a diluent. As for the replenishment method, a replenisher prepared by previously diluting the replenisher stock solution may be replenished to the developer, or a replenisher stock solution and a diluent may be separately replenished directly to the developer.

Also, in the present invention, the electric conductivity sensor for measuring the electric conductivity value of developer means a related art device such as AC electric conductivity meter, AC bridge meter and other electric conductivity meters. In addition, optimal conditions of measured current value, oscillating frequency and the like of the measuring device vary depending on the composition or the like of the developer, but in view of device or for preventing electrolysis of the water-soluble developer, the current value is preferably low to a certain extent, that is, from hundreds of mA to several µA. Furthermore, in view of relationship with the electrostatic capacity component in the developer, the frequency is preferably from hundreds of Hz to hundreds of kHz

The electric conductivity value of the developer containing an electrolyte depends on the temperature of the aqueous solution, and this value decreases as the liquid temperature rises. Accordingly, the electric conductivity is more preferably measured by a measuring device equipped with a temperature sensor and a temperature compensating circuit. Also, the temperature may be compensated by converting an actually measured liquid resistance value and liquid temperature into the electric conductivity value at a predetermined temperature in a control device of controlling the replenishment. The sensor of the AC electric conductivity meter, AC bridge meter or other electric conductivity meters may be disposed at any position as long as it is a place where the sensor can be immersed in the developer at the measurement and can measure the AC electric conductivity value of the developer. For example, the sensor is preferably disposed in the developer circulation system of an automatic developing apparatus, particularly, in the developing tank or in the circulation pipe. As for the detecting unit, a related art measuring cell using platinum, stainless steel or the like for the electrode can be used.

The object of the present invention has been attained by the following (1) to (4):

(1) A method for replenishing a development replenisher in an automatic developing machine, wherein the automatic developing machine develops a plurality of photosensitive lithographic printing plates that were exposed with a developer containing an electrolyte, the method comprising:

measuring an electric conductivity of the developer;
comparing the electric conductivity of the developer with a reference electric conductivity; and
replenishing a development replenisher containing an electric conductivity adjusting agent to the developer, when the electric conductivity of the developer is lower than the reference electric conductivity, so that the electric conductivity of the developer increases to keep an activity of the developer substantially constant.

(2) The method as described in (1) above,
wherein an electric conductivity calculated from a total amount of the plurality of photosensitive lithographic printing plates processed with the developer is used as the reference electric conductivity.

(3) The method as described in (1) or (2) above,
wherein an electric conductivity calculated from a replenisher replacement ratio is used as the reference electric conductivity,
wherein the replenisher replacement ratio is an amount ratio of the development replenisher, which is replenished to the developer, based on the developer.

(4) The method as described in any one of (1) to (3) above,
wherein an electric conductivity calculated from a replenisher replacement ratio and an aging replenishment ratio is used as the reference electric conductivity,

wherein the replenisher replacement ratio is an amount ratio of the development replenisher, which is replenished to the developer, based on the developer, and the aging replenishment ratio is a ratio of an aging replenishment amount, which is calculated from an operated time and a stopped time of the automatic developing machine, based on a total replenishment amount.

**Brief Description of the Drawings**

Fig. 1 is a constitutional view showing a first embodiment of the automatic developing machine used for practicing the development replenishment method according to the present invention;
Fig. 2 is a flow chart for explaining the fundamental control processing of replenishing the development replenisher;
Fig. 3 is a flow chart for explaining the first control processing;
Fig. 4 is a flow chart for explaining the second control processing;
Fig. 5 is a flow chart (1 of 2) for explaining the third control processing;
Fig. 6 is a flow chart (2 of 2) for explaining the third control processing; and
Fig. 7 is a constitutional view of the automatic developing machine according to the second embodiment of the present invention.

**Detailed Description of the Invention**

A development replenisher containing an electrolyte and an electric conductivity adjusting agent of elevating the electric conductivity is replenished based on previously established replenishing conditions to compensate the reduction of development activity occurred at the operation and/or stopping of an automatic developing apparatus, and when after replenishing a development replenisher based on previously established replenishing conditions to compensate the reduction of development activity caused due to processing of photosensitive materials, the measured value of electric conductivity of the developer replenished with the development replenisher is lower than the electric conductivity target value calculated by using a replenisher replacement ratio and/or an aging replenishment ratio and/or a developer diluting ratio, a diluent is replenished to the developing tank until the measured electric conductivity value exceeds the electric conductivity target value.
The alkali developing solution for use in the plate-making method for a lithographic printing plate of the present invention is described below.
The alkali developing solution (hereinafter sometimes simply referred to as a "developer") for use in the development processing is an alkaline aqueous solution and can be appropriately selected from related aqueous alkali solutions.
Example of the aqueous alkali solution include developers comprising an alkali silicate or nonreducing sugar and a base. In particular, those having a pH of 12.5 to 14.0 are preferred.
The alkali silicate shows alkalinity when dissolved in water, and examples thereof include alkali metal silicates such as sodium silicate, potassium silicate and lithium silicate, and ammonium silicate.
One alkali silicate may be used alone, or two or more alkali silicates may be used in combination.
The developing property of the aqueous alkali solution can be easily adjusted by controlling the mixing ratio of silicon oxide $SiO_2$ and alkali oxide $M_2O$ (M represents an alkali metal or an ammonium group) which are the silicate components, or controlling the concentration.
Among the above-described aqueous alkali solutions, those where the mixing ratio of silicon oxide $SiO_2$ to alkali oxide $M_2O$ ($SiO_2/M_2O$, by mol) is from 0.5 to 3.0 are preferred, and those where the mixing ratio is from 1.0 to 2.0 are more preferred.
If $SiO_2/M_2O$ is less than 0.5, the alkali strength becomes strong and this may cause troubles such that the general-purpose aluminum plate as the support of the lithographic printing plate precursor is etched, whereas if it exceeds 3.0, the developing property may decrease.
The concentration of alkali silicate in the developer is preferably from 1 to 10 weight%, more preferably from 3 to 8 weight%, and most preferably from 4 to 7 weight%, based on the weight of the aqueous alkali solution. If this concentration is less than 1 weight%, the developing property and processing ability may decrease, whereas if it exceeds 10 weight%, precipitate or crystal is readily produced or at the wastewater neutralization, gelling is liable to occur and the wastewater treatment may be disturbed.
In the developer comprising a nonreducing sugar and a base, the nonreducing sugar means sugars having no reducing property due to absence of a free aldehyde group or a free ketone group. The nonreducing sugar is classified into trehalose-type oligosaccharides where reducing groups are bonded with each other; glycosides where a reducing group of saccharide is bonded to a non-saccharide; and sugar alcohols produced by reducing a saccharide through hydrogenation. In the present invention, these nonreducing sugars all can be suitably used.
Examples of the trehalose-type oligosaccharide include saccharose and trehalose, and examples of the glycoside include alkyl glycosides, phenol glycosides and mustard oil glycosides.
Examples of the sugar alcohol include D,L-arabitol, ribitol, xylitol, D,L-sorbitol, D,L-mannitol, D,L-iditol, D,L-talitol, dulcitol and allodulcitol. Other suitable examples include maltitols obtained by the hydrogenation of disaccharides, and reduced products (reduced starch syrup) obtained by the hydrogenation of oligosaccharides.

Among these nonreducing sugars, preferred are sugar alcohols and saccharose, and more preferred are D-sorbitol, saccharose and reduced starch syrup because of their buffering activity in an appropriate pH region.

These nonreducing sugars may be used individually or in combination of two or more thereof. The ratio of the nonreducing agent in the developer is preferably from 0.1 to 30 weight%, more preferably from 1 to 20 weight%.

In combination with the alkali silicate or reducing sugar, an alkali agent appropriately selected from related alkali agents may be used as a base.

Examples of the alkali agent include sodium hydroxide, potassium hydroxide and lithium hydroxide.

Other suitable examples include organic alkali agents such as monomethylamine, dimethylamine, trimethylamine, monoethylamine, diethylamine, triethylamine, monoisopropylamine, diisopropylamine, triisopropylamine, n-butylamine, monoethanolamine, diethanolamine, triethanolamine, monoisopropanolamine, diisopropanolamine, ethyleneimine, ethylenediamine and pyridine.

These alkali agents may be used individually or in combination of two or more thereof. Among these alkali agents, sodium hydroxide and potassium hydroxide are preferred, because the pH can be adjusted over a wide pH region by controlling the amount of such an alkali agent based on the nonreducing sugar. Also, trisodium phosphate, tripotassium phosphate, sodium carbonate and potassium carbonate are preferred because of their own buffering activity.

The development replenisher for use in the present invention may further contain an electric conductivity adjusting agent. The electric conductivity adjusting agent as used in the present invention means a substance having a function of elevating the electric conductivity of the alkaline developer, and any substance may be used as long as it dissolves in an aqueous alkali solution, reacts with none of developer components, development replenisher components, photosensitive layer components, undercoat layer components and backcoat layer components, and exhibits electrophoretic property when dissolved in water. The electric conductivity adjusting agent includes an organic electrolyte and an inorganic electrolyte.

Among those compounds, the electric conductivity adjusting agent for use in the present invention is preferably a compound capable of elevating the electric conductivity by 2 to 10 mS/cm, preferably by 3 to 8 mS/cm, more preferably by 4 to 7 mS/cm, when added in a concentration of 0.01 to 10.0 weight% to a developer originally having an electric conductivity of 35 to 80 mS/cm. The electric conductivity adjusting agent is more preferably an inorganic or organic electrolyte satisfying the above-described condition and additionally, having a molecular weight of 1,500 or less, preferably 1,000 or less, more preferably from 100 to 800. The electric conductivity adjusting agent is most preferably a compound exhibiting, in addition to satisfy those conditions regarding elevation of electric conductivity and molecular weight, a pH of 3 to 10, preferably a pH of 3.5 to 9.5, more preferably a pH of 4 to 9, when the compound is formed into a 5 weight% aqueous solution.

Accordingly, the electric conductivity adjusting agent for use in the present invention is most preferably an inorganic or organic electrolyte (1) which dissolves in an aqueous alkali solution, reacts with none of the developer components, development replenisher components, photosensitive layer components, undercoat layer components and backcoat layer components, and exhibits an electrophoretic property when dissolved in water, (2) which can elevate the electric conductivity by 4 to 7 mS/cm when added in a concentration of 0.01 to 10.0 weight% to a developer originally having an electric conductivity of 35 to 80 mS/cm, (3) which has a molecular weight of 100 to 800, and (4) which exhibits a pH of 4 to 9 when formed into a 5 weight% aqueous solution.

The electric conductivity can be measured by using, for example, an electric conductivity meter manufactured by DKK-TOA Corporation.

Specific examples of the electric conductivity adjusting agent for use in the present invention include inorganic electrolytes such as carbonate, bicarbonate, phosphate, phosphite, hydrochloride, sulfate, sulfite, nitrate and nitrite of lithium, sodium, potassium, calcium, magnesium or ammonium, and organic electrolytes such as carboxylate, sulfonate and phosphonate of lithium, sodium, potassium, calcium, magnesium or ammonium.

More specific examples include carboxylates such as formate, acetate, propionate, butanate, oxalate, malonate, succinate and citrate, aromatic carboxylates such as benzoate, salicylate, sulfosalicylate and phthalate, and sulfonates such as lower alkyl sulfonate, benzenesulfonate, styrenesulfonate, xylenesulfonate, lower alkyl benzenesulfonate and benzenedisulfonate.

In the present invention, one of these electric conductivity adjusting agents may be used alone, or two or more thereof may be used in combination.

Among these electric conductivity adjusting agents, preferred are potassium citrate, sodium citrate, lithium citrate, potassium succinate, sodium succinate, lithium succinate, potassium carbonate, sodium carbonate and lithium carbonate. As described above, a developer comprising an alkali silicate or nonreducing sugar and a base is used as the alkaline developing solution, and the cation component related used therefor is $Li^+$, $Na^+$, $K^+$ or $NH_4^+$. In particular, a system comprising much cation having a small ionic radius has high penetrability into the image recording layer and excellent developing property, but this system dissolves even the image part to cause image defects. Accordingly, the

elevation of alkali concentration has limits to a certain extent and in order to completely perform the processing to allow for no remaining of image recording layer in the non-image part (residual film) without generating defects in the image part, subtle setting of liquid conditions is required.

However, when cation having a large ionic radius is used as the cation component, the developer can be prevented from penetration into the image recording layer and the effect of inhibiting dissolution of the image part can be enhanced without decreasing the alkali concentration, that is, the developing property.

As for the cation component, cation other than the above-described alkali metal cation and ammonium ion may be used.

In the alkali developing solution for use in the present invention, the following additives may be added so as to enhance the developing performance.

Examples of the additive include neutral salts such as NaCl, KCl and KBr described in JP-A-58-75152, chelating agents such as EDTA and NTA described in JP-A-58-190952, complexes such as $[Co(NH_3)_6]Cl_3$ and $CoCl_2 \cdot 6H_2O$ described in JP-A-59-121336, anion or amphoteric surfactants such as sodium alkylnaphthalenesulfonate, N-tetradecyl-N,N-dihydroxyethyl betaine described in JP-A-50-51324, nonionic surfactants such as tetramethyldecynediol described in U.S. Patent 4,374,920, cationic polymers such as methyl chloride quaternary compound of p-dimethylaminomethyl polystyrene described in JP-A-55-95946, amphoteric polymer electrolytes such as copolymer of vinylbenzyltrimethylammonium chloride and sodium acrylate described in JP-A-56-142528, reducing inorganic salts such as sodium sulfite described in JP-A-57-192951, inorganic lithium compounds such as lithium chloride described in JP-A-58-59444, organic metal surfactants comprising organic Si, Ti or the like described in JP-A-59-75255, organic boron compounds described in JP-A-59-84241, and quaternary ammonium salts such as tetraalkylammonium oxide described in EP-101010.

The lithographic printing plate processed by using an alkaline developing solution and a replenisher is after-treated with washing water, with a rinsing solution containing a surfactant or the like, or with a desensitizing solution containing gum arabic or starch derivative. This after-treatment may be performed by variously combining these processing solutions.

The heat-sensitive positive lithographic printing plate for use in the plate-making method of the present invention is described below.

Heat-Sensitive Positive Lithographic Printing Plate

The heat-sensitive positive lithographic printing plate for use in the plate-making method of the present invention comprises a support having provided thereon an image recording layer containing, as an essential component, an ultraviolet absorbing dye and usually further containing an alkali-soluble resin and the like.

The heat-sensitive positive lithographic printing plate (also called a "lithographic printing plate precursor") is described in detail below. The construction of the image recording layer is described.

Infrared Absorbing Dye

In the present invention, the infrared absorbing dye used for the image recording layer is not particularly limited as long as it is a dye of absorbing infrared ray and generating heat, and various dyes in related art as the infrared absorbing dye can be used.

As for the infrared absorbing dye, commercially available dyes and related art dyes described in publications (for example, Senryo Binran (Handbook of Dyes), compiled by Yuki Gosei Kagaku Kyokai (1970)) may be used. Specific examples thereof include dyes such as azo dye, metal complex salt azo dye, pyrazolone azo dye, quinoneimine dye, methine dye and cyanine dye. Among these, dyes of absorbing infrared or near infrared light are preferred in the present invention, because such dyes are suitable for use with a laser of emitting infrared or near infrared light.

Examples of the dye which absorbs infrared or near infrared light include cyanine dyes described in JP-A-58-125246, JP-A-59-84356, JP-A-59-202829 and JP-A-60-78787, methine dyes described in JP-A-58-173696, JP-A-58-181690 and JP-A-58-194595, naphthoquinone dyes described in JP-A-58-112793, JP-A-58-224793, JP-A-59-48187, JP-A-59-73996, JP-A-60-52940 and JP-A-60-63744, squarylium dyes described in JP-A-58-112792, and cyanine dyes described in British Patent 434,875.

Furthermore, near infrared absorbing sensitizers described in U.S. Patent 5,156,938 may also be suitably used as the dye. In particular, substituted arylbenzo-(thio)pyrylium salts described in U.S. Patent 3,881,924, trimethinethiapyrylium salts described in JP-A-57-142645 (corresponding to U.S. Patent 4,327,169), pyrylium-based compounds described in JP-A-58-181051, JP-A-58-220143, JP-A-59-41363, JP-A-59-84248, JP-59-84249, JP-A-59-146063 and JP-A-59-146061, cyanine dyes described in JP-A-59-216146, pentamethinethiapyrylium salts described in U.S. Patent 4,283,475, pyrylium compounds described in JP-B-5-13514 (the term "JP-B" as used herein means an "examined Japanese patent publication") and JP-B-5-19702, and commercially available products such as

Epolight III-178, Epolight III-130 and Epolight III-125 produced by Epolin Co., Ltd. are preferably used.

Particularly preferred examples of the infrared absorbing dye for use in the image recording layer include infrared absorbing dyes represented by formulae (I) and (II) of U.S. Patent 4,756,993. Such a dye very strongly interacts with the alkali-soluble resin and assures excellent alkali development resistance in the unexposed part of the image recording layer.

The amount added of the infrared absorbing dye in the image recording layer is, in view of sensitivity and uniformity of image recording layer, from 0.01 to 50 weight%, preferably from 0.1 to 50 weight%, more preferably from 0.1 to 30 weight%, based on the weight of the image recording layer.

Specific examples of the infrared absorbing dye are set forth below, but the present invention is not limited thereto.

Cyanine Dye A:

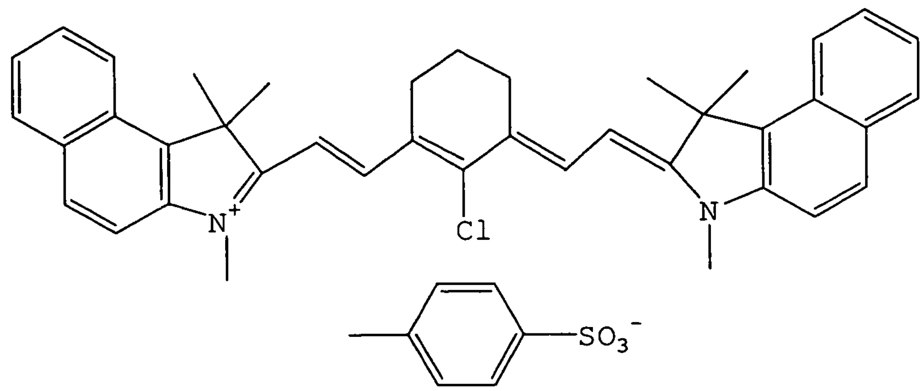

Cyanine Dye B:

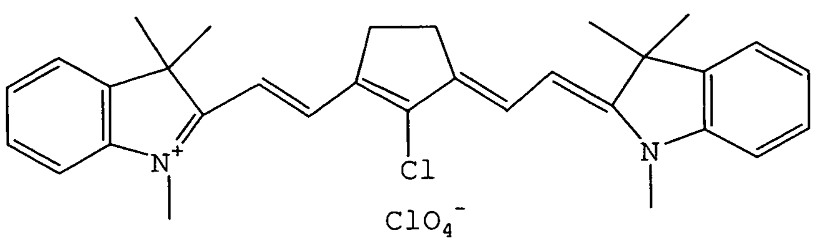

Cyanine Dye C:

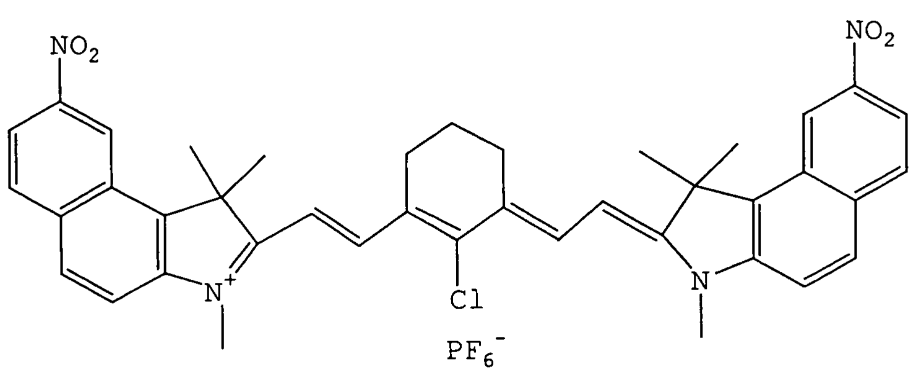

Cyanine Dye D:

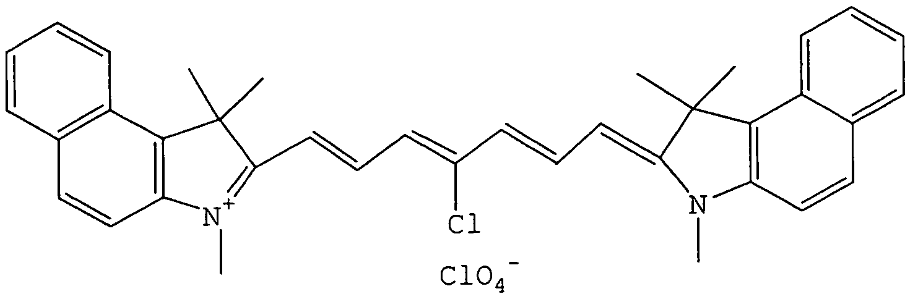

Cyanine Dye E:

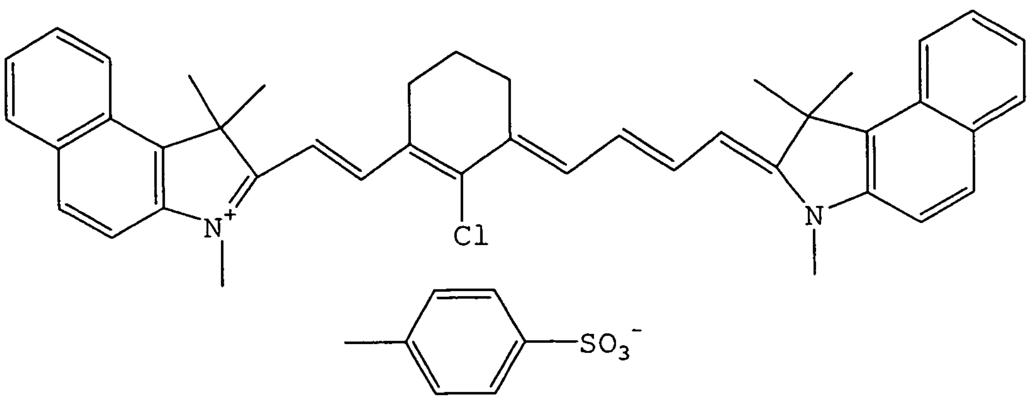

Alkali-Soluble Resin

The alkali-soluble resin for use in the image recording layer is a water-insoluble and alkali water-soluble resin (hereinafter, conveniently referred to as an "alkali-soluble polymer") and includes homopolymers containing an acidic group on the main chain and/or side chain in the polymer, and copolymers or mixtures thereof. Accordingly, the image recording layer of the lithographic printing plate precursor has a property of being dissolved when contacted with an alkaline developer.

The alkali-soluble polymer for use in the image recording layer is not particularly limited as long as it is a related alkali-soluble polymer, but is preferably a polymer having any one functional group of (1) a phenolic hydroxyl group, (2) a sulfonamide group and (3) an active imide group, within the molecule. Examples thereof include, but are not limited to, the followings.

Examples of the polymer compound having (1) a phenolic hydroxyl group include novolak resins such as phenol-formaldehyde resin, m-cresol-formaldehyde resin, p-cresol-formaldehyde resin, m-/p-mixed cresol-formaldehyde resin, and phenol/(m-, p- or m-/p-mixed) cresol mixed formaldehyde resin, and pyrogallol acetone resins. Other than these, a polymer compound having a phenolic hydroxyl group on the side chain is preferably used as the polymer compound having a phenolic hydroxyl group. Examples of the polymer compound having a phenolic hydroxyl group on the side chain include polymer compounds obtained by homopolymerizing a polymerizable monomer comprising a low molecular compound having one or more phenolic hydroxyl group and one or more polymerizable unsaturated bond, or by copolymerizing this monomer with another polymerizable monomer.

Examples of the polymerizable monomer having a phenolic hydroxyl group include an acrylamide, a methacrylamide, an acrylic acid ester, a methacrylic acid ester and a hydroxystyrene, each having a phenolic hydroxyl group. Specific preferred examples thereof include N-(2-hydroxyphenyl)acrylamide, N-(3-hydroxyphenyl)acrylamide, N-(4-hydroxyphenyl)acrylamide, N-(2-hydroxyphenyl)methacrylamide, N-(3-hydroxyphenyl)methacrylamide, N-(4-hydroxyphenyl)methacrylamide, o-hydroxyphenyl acrylate, m-hydroxyphenyl acrylate, p-hydroxyphenyl acrylate, o-hydroxyphenyl methacrylate, m-hydroxyphenyl methacrylate, p-hydroxyphenyl methacrylate, o-hydroxystyrene, m-hydroxystyrene, p-hydroxystyrene, 2-(2-hydroxyphenyl)ethyl acrylate, 2-(3-hydroxyphenyl)ethyl acrylate, 2-(4-hydroxyphenyl)ethyl acrylate, 2-(2-hydroxyphenyl)ethyl methacrylate, 2-(3-hydroxyphenyl)ethyl methacrylate and 2-(4-hydroxyphenyl)ethyl methacrylate. These resins having a phenolic hydroxyl group may be used in combination of two or more thereof. Furthermore, as described in U.S. Patent 4,123,279, a copolymer of formaldehyde and phenol containing, as a substituent, an alkyl group having from 3 to 8 carbon atoms, such as tert-butyl phenol formaldehyde resin and octyl phenol formaldehyde resin, may be used in combination.

Examples of the alkali-soluble polymer compound having (2) a sulfonamide group include polymer compounds obtained by homopolymerizing a polymerizable monomer having a sulfonamide group, or by copolymerizing this monomer with another polymerizable monomer. Examples of the polymerizable monomer having a sulfonamide group include polymerizable monomers comprising a low molecular compound having, within one molecule, one or more polymerizable unsaturated bond and one or more sulfonamide group $-NH-SO_2-$ where at least one hydrogen atom is bonded on the nitrogen atom. Among these, preferred are low molecular compounds having an acryloyl, aryl or vinyloxy group and a substituted or mono-substituted aminosulfonyl group or a substituted sulfonylimino group.

The alkali-soluble polymer compound having (3) an active imide group is preferably a polymer compound having an active imide group within the molecule, and examples of this polymer compound include polymer compounds obtained by homopolymerizing a polymerizable monomer comprising a low molecular compound having one or more active imide group and one or more polymerizable unsaturated bond within one molecule, or by copolymerizing this monomer with another polymerizable monomer.

Specific examples of this polymer compound which can be suitably used include N-(p-toluenesulfonyl)methacrylamide and N-(p-toluenesulfonyl)acrylamide.

The alkali-soluble polymer compound is preferably a polymer compound obtained by polymerizing two or more members out of the above-described polymerizable monomers having a phenolic hydroxyl group, polymerizable monomers having a sulfonamide group, and polymerizable monomers having an active imide group, or a polymer compound obtained by copolymerizing two or more members out of these polymerizable monomers with another polymerizable monomer. In the case of copolymerizing a polymerizable monomer having a phenolic hydroxyl group with a polymerizable monomer having a sulfonamide group and/or a polymerizable monomer having an active imide group, the weight ratio of the components blended is preferably from 50:50 to 5:95, more preferably from 40:60 to 10:90.

In the case where the alkali-soluble polymer is a copolymer of the above-described polymerizable monomer having a phenolic hydroxyl group, a sulfonamide group or an active imide group with another polymerizable monomer, the copolymer preferably contains 10 mol% or more, more preferably 20 mol% or more, of the monomer of imparting alkali solubility so as to ensure sufficiently high alkali solubility and satisfactorily bring out the effect of enhancing the developing latitude.

Examples of the monomer component which is copolymerized with the polymerizable monomer having a phenolic hydroxyl group, polymerizable monomer having a sulfonamide group or polymerizable monomer having active imide group include, but are not limited to, the compounds shown in (m1) to (m12) below.

(m1) Acrylic acid esters and methacrylic acid esters each having an aliphatic hydroxyl group, such as 2-hydroxyethyl acrylate and 2-hydroxyethyl methacrylate.
(m2) Alkyl acrylates such as methyl acrylate, ethyl acrylate, propyl acrylate, butyl acrylate, amyl acrylate, hexyl acrylate, octyl acrylate, benzyl acrylate, 2-chloroethyl acrylate and glycidyl acrylate.
(m3) Alkyl methacrylates such as methyl methacrylate, ethyl methacrylate, propyl methacrylate, butyl methacrylate, amyl methacrylate, hexyl methacrylate, cyclohexyl methacrylate, benzyl methacrylate, 2-chloroethyl methacrylate and glycidyl methacrylate.
(m4) Acrylamides and methacrylamides, such as acrylamide, methacrylamide, N-methylolacrylamide, N-ethylacrylamide, N-hexylmethacrylamide, N-cyclohexylacrylamide, N-hydroxyethylacrylamide, N-phenylacrylamide, N-nitrophenylacrylamide and N-ethyl-N-phenylacrylamide.
(m5) Vinyl ethers such as ethyl vinyl ether, 2-chloroethyl vinyl ether, hydroxyethyl vinyl ether, propyl vinyl ether, butyl vinyl ether, octyl vinyl ether and phenyl vinyl ether.
(m6) Vinyl esters such as vinyl acetate, vinyl chloroacetate, vinyl butyrate and vinyl benzoate.
(m7) Styrenes such as styrene, $\alpha$-methylstyrene, methylstyrene and chloromethylstyrene.
(m8) Vinyl ketones such as methyl vinyl ketone, ethyl vinyl ketone, propyl vinyl ketone and phenyl vinyl ketone.
(m9) Olefins such as ethylene, propylene, isobutylene, butadiene and isoprene.
(m10) N-Vinylpyrrolidone, N-vinylcarbazole, 4-vinylpyridine, acrylonitrile, methacrylonitrile and the like.
(m11) Unsaturated imides such as maleimide, N-acryloylacrylamide, N-acetylmethacrylamide, N-propionylmethacrylamide and N-(p-chlorobenzoyl)methacrylamide.
(m12) Unsaturated carboxylic acids such as acrylic acid, methacrylic acid, maleic anhydride and itaconic acid.

The alkali-soluble polymer compound preferably has a phenolic hydroxyl group, because excellent image formability is attained upon exposure with an infrared laser or the like, and preferred examples thereof include novolak resins such as phenol-formaldehyde resin, m-cresol-formaldehyde resin, p-cresol-formaldehyde resin, m-/p-mixed cresol-formaldehyde resin, and phenol/(m-, p- or m-/p-mixed) cresol mixed formaldehyde resin, and pyrogallol acetone resins.

Other examples of the alkali-soluble polymer compound having a phenolic hydroxyl group include condensation polymerized products of formaldehyde and phenol containing, as a substituent, an alkyl group having from 3 to 8 carbon atoms, such as tert-butyl phenol formaldehyde resin and octyl phenol formaldehyde resin, described in U.S. Patent 4,123,279.

With respect to the method for copolymerization of the alkali-soluble polymer compound, related art methods such as graft copolymerization, block copolymerization and random copolymerization can be used.

In the present invention, when the alkali-soluble polymer is a homopolymer or copolymer of the above-described polymerizable monomer having a phenolic hydroxyl group, polymerizable monomer having a sulfonamide group or polymerizable monomer having an active imide group, the polymer preferably has a weight average molecular weight of 2,000 or more and a number average molecular weight of 500 or more, more preferably a weight average molecular weight of 5,000 to 300,000, a number average molecular weight of 800 to 250,000 and a dispersity (weight average molecular weight/number average molecular weight) of 1.1 to 10.

Also, in the present invention, when the alkali-soluble polymer is a resin such as phenol-formaldehyde resin or cresol-aldehyde resin, the polymer preferably has a weight average molecular weight of 500 to 20,000 and a number average molecular weight of 200 to 10,000.

These alkali-soluble polymer compounds may be used individually or in combination of two or more thereof, and the content of the alkali-soluble polymer compound is from 30 to 99 weight%, preferably from 40 to 95 weight%, more preferably from 50 to 90 weight%, based on the entire solid content in the image-forming layer. The content in this range is preferred from both aspects of durability and sensitivity of the image-forming layer.

The image-forming layer may also contain an alkali-soluble polymer compound having a carboxyl group (hereinafter sometimes referred to as a "component (B1)").

The polymer compound as the component (B1) may be any compound as long as it is an alkali-soluble polymer compound having a carboxyl group, but polymer compounds (b1-1) and (b1-2) defined below are preferred.

(b1-1) Alkali-Soluble Polymer Compound Having Polymerizable Monomer Unit Represented by Formula (i) (hereinafter sometimes referred to as a "polymer compound (b1-1)")

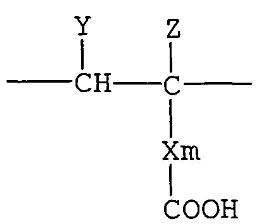

(i)

(wherein Xm represents a single bond or a divalent linking group, Y represents hydrogen or a carboxyl group, and Z represents hydrogen, an alkyl group or a carboxyl group).

The monomer constituting the polymerizable monomer unit represented by formula (i) includes a polymerizable monomer containing one or more carboxyl group and one or more polymerizable unsaturated group within the molecule.

Specific examples of such a polymerizable monomer include α,β-unsaturated carboxylic acids such as acrylic acid, methacrylic acid, maleic acid, maleic anhydride, itaconic acid and itaconic anhydride.

Examples of the monomer which is copolymerized with the above-described polymerizable monomer having a carboxyl group include, but are not limited to, those described in the following (1) to (11).

(1) Acrylic acid esters and methacrylic acid esters each having an aliphatic hydroxyl group, such as 2-hydroxyethyl acrylate and 2-hydroxyethyl methacrylate.

(2) Alkyl acrylates such as methyl acrylate, ethyl acrylate, propyl acrylate, butyl acrylate, amyl acrylate, hexyl acrylate, octyl acrylate, benzyl acrylate, 2-chloroethyl acrylate, glycidyl acrylate and N-dimethylaminoethyl acrylate.

(3) Alkyl methacrylates such as methyl methacrylate, ethyl methacrylate, propyl methacrylate, butyl methacrylate, amyl methacrylate, hexyl methacrylate, cyclohexyl methacrylate, benzyl methacrylate, 2-chloroethyl methacrylate, glycidyl methacrylate and N-dimethylaminoethyl methacrylate.

(4) Acrylamides and methacrylamides, such as acrylamide, methacrylamide, N-methylolacrylamide, N-ethylacrylamide, N-hexylmethacrylamide, N-cyclohexylacrylamide, N-hydroxyethylacrylamide, N-phenylacrylamide, N-nitrophenylacrylamide and N-ethyl-N-phenylacrylamide.

(5) Vinyl ethers such as ethyl vinyl ether, 2-chloroethyl vinyl ether, hydroxyethyl vinyl ether, propyl vinyl ether, butyl vinyl ether, octyl vinyl ether and phenyl vinyl ether.

(6) Vinyl esters such as vinyl acetate, vinyl chloroacetate, vinyl butyrate and vinyl benzoate.

(7) Styrenes such as styrene, α-methylstyrene, methylstyrene and chloromethylstyrene.

(8) Vinyl ketones such as methyl vinyl ketone, ethyl vinyl ketone, propyl vinyl ketone and phenyl vinyl ketone.

(9) Olefins such as ethylene, propylene, isobutylene, butadiene and isoprene.

(10) N-Vinylpyrrolidone, N-vinylcarbazole, 4-vinylpyridine, acrylonitrile, methacrylonitrile and the like.

(11) Unsaturated imides such as maleimide, N-acryloylacrylamide, N-acetylmethacrylamide, N-propionylmethacrylamide and N-(p-chlorobenzoyl)methacrylamide.

The monomer represented by the following formula (ii) is also preferably used.

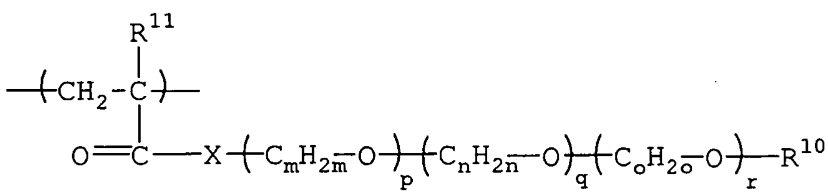

(ii)

wherein X represents O, S or N-$R^{12}$, $R^{10}$ to $R^{12}$ each independently represents a hydrogen atom or an alkyl group, m, n and o each independently represents an integer of 2 to 5, $C_mH_{2m}$, $C_nH_{2n}$ and $C_oH_{2o}$ each may be a straight chain or a branched structure, p, q and r each independently represents an integer of 0 to 3,000, and $p+q+r \geq 2$.

The alkyl group in $R^{10}$ to $R^{12}$ is preferably an alkyl group having from 1 to 12 carbon atoms, and specific examples thereof include a methyl group, an ethyl group, an n-propyl group and an isopropyl group. p, q and r each preferably represents an integer of 0 to 500, more preferably an integer of 0 to 100.

Examples of the monomer corresponding to the repeating unit represented by formula (ii) include, but are not limited to, the followings.

(1)

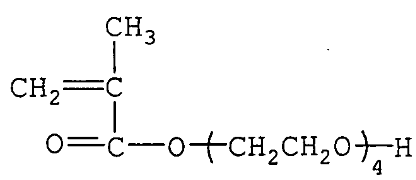

(2)

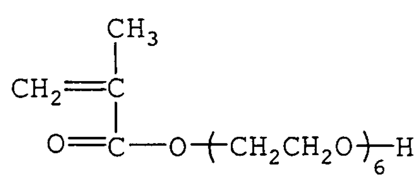

(3)

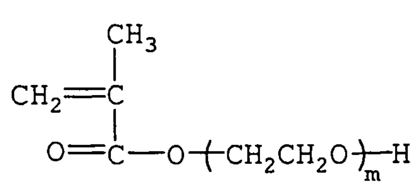

(average molecular weight of alkylene oxide: 1,000)

(4) 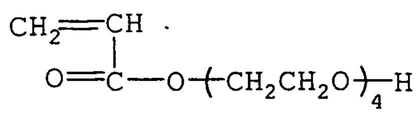

(5) 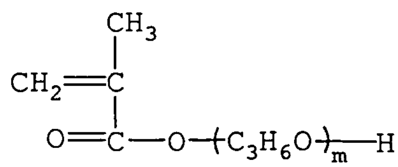

(average molecular weight of alkylene oxide: 1,000)

(6) 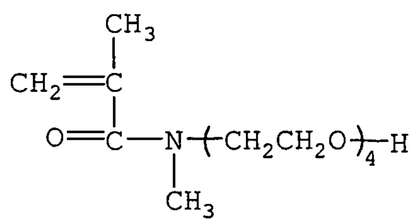

(7) 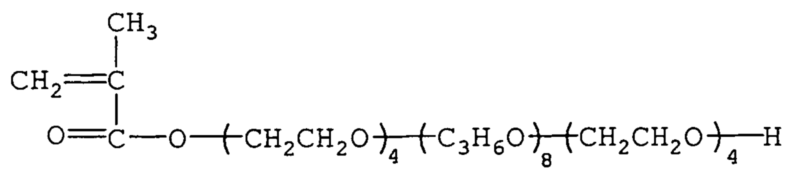

(8) 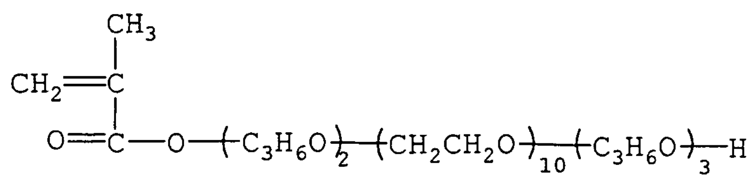

(9) 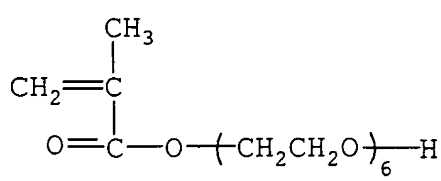

(10) 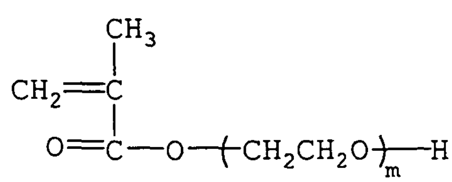

(average molecular weight of alkylene oxide: 500)

(11) 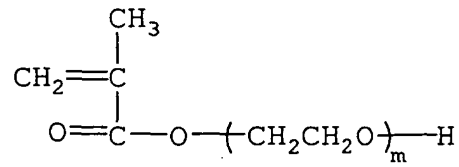

(average molecular weight of alkylene oxide: 2,000)

(12) 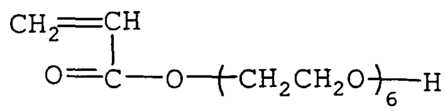

(13) 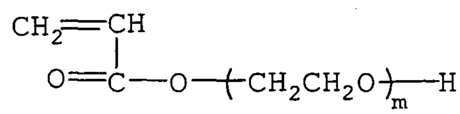

(average molecular weight of alkylene oxide: 1,500)

(14) 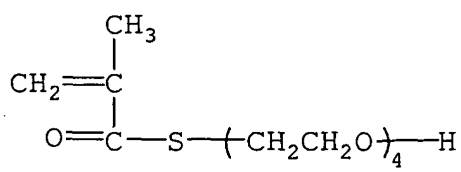

The repeating unit represented by formula (ii) can be produced by reacting a commercially available hydroxypoly(oxyalkylene) material, for example, a material available under the trade name of Pluronic (produced by Asahi Denka Kogyo K.K.), Adeka Polyether (produced by Asahi Denka Kogyo K.K.), Carbowax (produced by Glico Products), Toriton (produced by Rohm and Haas) or P.E.G (produced by Dai-ichi Kogyo Seiyaku Co., Ltd.), with an acrylic acid, a methacrylic acid, an acryl chloride, a methacryl chloride, an acrylic anhydride or the like according to a related art method.

Other than that produced above, poly(oxyalkylene) diacrylate produced by a related art method may also be used.

Examples of the commercially available monomer include hydroxy group-terminated polyalkylene glycol mono (meth)acrylates produced by NOF, such as Blemmer PE-90, Blemmer PE-200, Blemmer PE-350, Blemmer AE-90, Blemmer AE-200, Blemmer AE-400, Blemmer PP-1000, Blemmer PP-500, Blemmer PP-800, Blemmer AP-150, Blemmer AP-400, Blemmer AP-550, Blemmer AP-800, Blemmer 50 PEP-300, Blemmer 70 PEP-350B, Blemmer AEP Series, Blemmer 55 PET-400, Blemmer 30 PET-800, Blemmer 55 PET-800, Blemmer AET Series, Blemmer 30 PPT-800, Blemmer 50 PPT-800, Blemmer 70 PPT-800, Blemmer APT Series, Blemmer 10 PPB-500B and Blemmer 10 APB-500B; alkyl-terminated polyalkylene glycol mono(meth)acrylates produced by NOF, such as Blemmer PME-100, Blemmer PME-200, Blemmer PME-400, Blemmer PME-1000, Blemmer PME-4000, Blemmer AME-400, Blemmer 50 POEP-800B, Blemmer 50 AOEP-800B, Blemmer PLE-200, Blemmer ALE-200, Blemmer ALE-800, Blemmer PSE-400, Blemmer PSE-1300, Blemmer ASEP Series, Blemmer PKEP Series, Blemmer AKEP Series, Blemmer ANE-300, Blemmer ANE-1300, Blemmer PNEP Series, Blemmer PNPE Series, Blemmer 43 ANEP-500, Blemmer 70 ANEP-550; and monomers produced by Kyoeisha Chemical Co., Ltd., such as Light Ester MC, Light Ester 130MA, Light Ester 041MA, Light Acrylate BO-A, Light Acrylate EC-A, Light Acrylate MTG-A, Light Acrylate 130A, Light Acrylate DPM-A, Light Acrylate P-200A, Light Acrylate NP-4EA and Light Acrylate NP-8EA.

In the polymer compound (b1-1), the minimum constituent unit comprising a polymerizable monomer component having one or more carboxyl group and one or more polymerizable unsaturated group within the molecule is

not particularly limited to comprise only one unit but may be a constituent unit obtained by copolymerizing two or more minimum constituent units having the same acidic group or by copolymerizing two or more minimum constituent units differing in the acidic group contained therein.

As for the copolymerization method, related art methods such as graft copolymerization, block copolymerization and random copolymerization may be used.

(b1-2) Carboxyl Group-Containing Alkali-Soluble Polymer Compound with Basic Skeleton being Reaction Product of Diol Compound Having Carboxyl Group Represented by Formula (iii), (iv) or (v) and Diisocyanate Compound Represented by Formula (viii) (hereinafter, this compound is sometimes referred to as a "polymer compound (b1-2)")

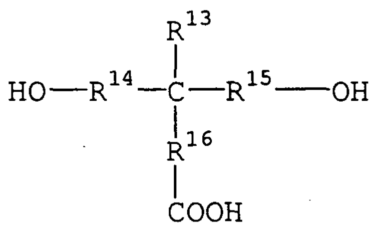

(iii)

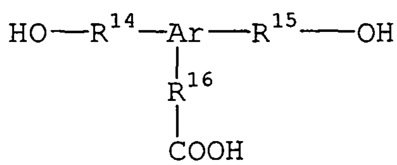

(iv)

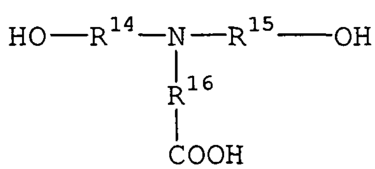

(v)

$R^{13}$ represents a hydrogen atom or an alkyl, alkenyl, aralkyl, aryl, alkoxy or aryloxy group which may have a substituent (preferably, for example, an alkyl group, an aryl group, an alkoxy group, an ester group, a urethane group, an amido group, a ureido group or a halogeno group), and preferably represents a hydrogen atom, an alkyl group having from 1 to 8 carbon atoms, an alkenyl group having from 2 to 8 carbon atoms or an aryl group having from 6 to 15 carbon atoms.

$R^{14}$, $R^{15}$ and $R^{16}$, which may be the same or different, each represents a single bond or a divalent aliphatic or aromatic hydrocarbon which may have a substituent (preferably, for example, an alkyl group, an alkenyl group, an aralkyl group, an aryl group, an alkoxy group or a halogeno group), and preferably represents an alkylene group having from 1 to 20 carbon atoms or an arylene group having 6 to 15 carbon atoms, more preferably an alkylene group having from 1 to 8 carbon atoms.

If desired, $R^{14}$, $R^{15}$ and $R^{16}$ each may contain another functional group which does not react with the isocyanate group, for example, an ester group, a urethane group, an amido group, a ureido group or a carbon-carbon unsaturated bond. Two or three of $R^{13}$, $R^{14}$, $R^{15}$ and $R^{16}$ may form a ring.

Ar represents a trivalent aromatic hydrocarbon which may have a substituent, and preferably represents an aromatic group having from 6 to 15 carbon atoms.

$$OCN\text{-}R^{18}\text{-}NCO \qquad \text{(viii)}$$

wherein $R^{18}$ represents a divalent aliphatic or aromatic hydrocarbon which may have a substituent (preferably, for example, an alkyl group, an alkenyl group, an aralkyl group, an aryl group, an alkoxy group or a halogeno group). If desired, $R^{18}$ may contain another functional group which does not react with the isocyanate group, for example, an

ester group, a urethane group, an amido group, a ureido group or a carbon-carbon unsaturated bond.

Specific examples of the diol compounds having a carboxyl group represented by formulae (iii), (iv) and (v) include:

3,5-dihydroxybenzoic acid, 2,2-bis(hydroxymethyl)propionic acid, 2,2-bis(2-hydroxyethyl)propionic acid, 2,2-bis (3-hydroxypropyl)propionic acid, bis(hydroxymethyl)acetic acid, bis(4-hydroxyphenyl)acetic acid, 4,4-bis(4-hydroxyphenyl)pentanoic acid, tartaric acid and N,N-bis(2-hydroxyethyl)-3-carboxy-propionamide.

The carboxyl group-containing alkali-soluble polymer compound (b1-2) is preferably a reaction product combined with a diol represented by the following formula (vi) or (vii):

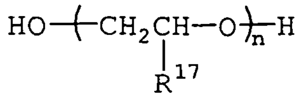

(vi)

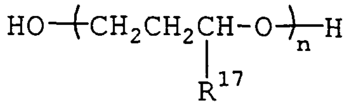

(vii)

wherein each $R^{17}$ represents a hydrogen atom or an alkyl group having from 1 to 8 carbon atoms, and n represents an integer of 2 or more. Examples of the alkyl group having from 1 to 8 carbon atoms in $R^{17}$ include a methyl group, an ethyl group, an i-propyl group, an n-butyl group and an i-butyl group.

Specific examples of diols represented by formulae (vi) and (vii) are set forth below, but the present invention is not limited thereto.

Specific examples of (vi):

$$HO\text{-}(\text{-}CH_2CH_2O\text{-})_3\text{-}H$$

$$HO\text{-}(\text{-}CH_2CH_2O\text{-})_4\text{-}H$$

$$HO\text{-}(\text{-}CH_2CH_2O\text{-})_5\text{-}H$$

$$HO\text{-}(\text{-}CH_2CH_2O\text{-})_6\text{-}H$$

$$HO\text{-}(\text{-}CH_2CH_2O\text{-})_7\text{-}H$$

$$HO\text{-}(\text{-}CH_2CH_2O\text{-})_8\text{-}H$$

$$HO\text{-}(\text{-}CH_2CH_2O\text{-})_{10}\text{-}H$$

$$HO\text{-}(\text{-}CH_2CH_2O\text{-})_{12}\text{-}H$$

Polyethylene glycol (average molecular weight: 1,000)

Polyethylene glycol (average molecular weight: 2,000)
Polyethylene glycol (average molecular weight: 4,000)

$$HO\text{-}(\text{-}CH_2CH(CH_3)O\text{-})_3\text{-}H$$

$$HO\text{-}(\text{-}CH_2CH(CH_3)O\text{-})_4\text{-}H$$

$$HO\text{-}(\text{-}CH_2CH(CH_3)O\text{-})_6\text{-}H$$

Polypropylene glycol (average molecular weight: 1,000)
Polypropylene glycol (average molecular weight: 2,000)
Polypropylene glycol (average molecular weight: 4,000)

Specific examples of (vii):

$$HO\text{-}(\text{-}CH_2CH_2CH_2O\text{-})_3\text{-}H$$

$$HO\text{-}(\text{-}CH_2CH_2CH_2O\text{-})_4\text{-}H$$

$$HO\text{-}(\text{-}CH_2CH_2CH_2O\text{-})_8\text{-}H$$

$$HO\text{-}(\text{-}CH_2CH_2CH(CH_3)O\text{-})_{12}\text{-}H$$

Specific examples of the diisocyanate compound represented by formula (viii) include:

aromatic diisocyanate compounds such as 2,4-tolylene diisocyanate, dimer of 2,4-tolylene diisocyanate, 2,6-tolylene diisocyanate, p-xylylene diisocyanate, m-xylylene diisocyanate, 4,4'-diphenyl methane diisocyanate, 1,5-naphthalene diisocyanate and 3,3'-dimethylbiphenyl-4,4'-diisocyanate; aliphatic diisocyanate compounds such as hexamethylene diisocyanate, trimethylhexamethylene diisocyanate, lysine diisocyanate and dimeric acid diisocyanate; aliphatic diisocyanate compounds such as isophorone diisocyanate, 4,4'-methylenebis(cyclohexyl isocyanate), methylcyclohexane-2,4(or 2,6)-diisocyanate, and 1,3-(isocyanatomethyl)cyclohexane; and diisocyanate compounds obtained by the reaction of diol and diisocyanate, such as an adduct of 1 mol of 1,3-butylene glycol and 2 mol of tolylene diisocyanate.

The molar ratio of a diisocyanate and a diol compound used for the synthesis of polymer compound (b1-2) is preferably from 0.8:1 to 1.2 to 1 and when an isocyanate group is remaining at the polymer terminal, the compound is treated with an alcohol or an amine and thereby finally synthesized in the form of allowing for no residual isocyanate group.

As for the component (B1), one compound selected from the polymer compounds (b1-1) and (b1-2) may be used alone, or two or more thereof may be used in combination.

The content of the carboxyl group-containing repeating unit contained in the component (B1) is 2 mol% or more, preferably from 2 to 70 mol%, more preferably from 5 to 60 mol%, based on the total amount of respective monomers in the component (B1).

The weight average molecular weight of the component (B1) is preferably from 3,000 to 300,000, more preferably from 6,000 to 100,000.

The amount added of the component (B1) is preferably from 0.005 to 80 weight%, more preferably from 0.01 to 50 weight%, still more preferably from 1 to 20 weight%, based on the entire solid content weight of the image recording layer.

Additives

In forming the image recording layer, various additives may be added, if desired, in addition to the above-described components as long as the effect of the present invention is not impaired.

-Solubility Inhibiting Compound-

In the lithographic printing plate precursor, various inhibitors may be incorporated into the image recording layer so as to enhance the inhibition (solubility inhibition).
The inhibitor is not particularly limited, but examples thereof include quaternary ammonium salts and polyethylene glycol-based compounds.
The quaternary ammonium salt is not particularly limited, but examples thereof include tetraalkylammonium salts, trialkylarylammonium salts, dialkyldiarylammonium salts, alkyltriarylammonium salts, tetraarylammonium salts, cyclic ammonium salts and dicyclic ammonium salts.
Specific examples thereof include tetrabutylammonium bromide, tetrapentylammonium bromide, tetrahexylammonium bromide, tetraoctylammonium bromide, tetralaurylammonium · bromide, tetraphenylammonium bromide, tetranaphthylammonium bromide, tetrabutylammonium chloride, tetrabutylammonium iodide, tetrastearylammonium bromide, lauryltrimethylammonium bromide, stearyltrimethylammonium bromide, behenyltrimethylammonium bromide, lauryltriethylammonium bromide, phenyltrimethylammonium bromide, 3-trifluoromethylphenyltrimethylammonium bromide, benzyltrimethylammonium bromide, dibenzyldimethylammonium bromide, distearyldimethylammonium bromide, tristearylmethylammonium bromide, benzyltriethylammonium bromide, hydroxyphenyltrimethylammonium bromide and N-methylpyridinium bromide. In particular, the quaternary ammonium salts described in Japanese Patent Application Nos. 2001-226297, 2001-370059 and 2001-398047 are preferred.
The amount added of the quaternary ammonium salt is preferably from 0.1 to 50 weight%, more preferably from 1 to 30 weight%, as the solid content based on the entire solid content amount of the image recording layer. The content within this range is proper in that a sufficiently high solubility inhibiting effect is brought out and the film-forming property of binder is not deteriorated.
The polyethylene glycol-based compound is not particularly limited, but examples thereof include those having the following structure:

$$R^1\text{-}\{\text{-O-}(R^3\ \text{-O-})_m\text{-}R^2\}_n$$

(wherein $R^1$ is a polyhydric alcohol residue or a polyhydric phenol residue, $R^2$ represents a hydrogen atom or an alkyl, alkenyl, alkynyl, alkyloyl, aryl or aryloyl group having from 1 to 25 carbon atoms, which may have a substituent, $R^3$ represents an alkylene residue which may have a substituent, m represents an integer of 10 or more on average, and n is an integer of 1 to 4).
Examples of the polyethylene glycol-based compound having the structure shown above include polyethylene glycols, polypropylene glycols, polyethylene glycol alkyl ethers, polypropylene glycol alkyl ethers, polyethylene glycol aryl ethers, polypropylene glycol aryl ethers, polyethylene glycol alkylaryl ethers, polypropylene glycol alkylaryl ethers, polyethylene glycol glycerin esters, polypropylene glycol glycerin esters, polyethylene sorbitol esters, polypropylene glycol sorbitol esters, polyethylene glycol fatty acid esters, polypropylene glycol fatty acid esters, polyethylene glycolated ethylenediamines, polypropylene glycolated ethylenediamines, polyethylene glycolated diethylenetriamines and polypropylene glycolated diethylenetriamines.
Specific examples thereof include polyethylene glycol 1000, polyethylene glycol 2000, polyethylene glycol 4000, polyethylene glycol 10000, polyethylene glycol 20000, polyethylene glycol 5000, polyethylene glycol 100000, polyethylene glycol 200000, polyethylene glycol 500000, polypropylene glycol 1500, polypropylene glycol 3000, polypropylene glycol 4000, polyethylene glycol methyl ether, polyethylene glycol ethyl ether, polyethylene glycol phenyl ether, polyethylene glycol dimethyl ether, polyethylene glycol diethyl ether, polyethylene glycol diphenyl ether, polyethylene glycol lauryl ether, polyethylene glycol dilauryl ether, polyethylene glycol nonyl ether, polyethylene glycol cetyl ether, polyethylene glycol stearyl ether, polyethylene glycol distearyl ether, polyethylene glycol behenyl ether, polyethylene glycol dibehenyl ether, polypropylene glycol methyl ether, polypropylene glycol ethyl ether, polypropylene glycol phenyl ether, polypropylene glycol dimethyl ether, polypropylene glycol diethyl ether, polypropylene glycol diphenyl ether, polypropylene glycol lauryl ether, polypropylene glycol dilauryl ether, polypropylene glycol nonyl ether, polyethylene glycol acetyl ester, polyethylene glycol diacetyl ester, polyethylene glycol benzoic acid ester, polyethylene glycol lauryl ester, polyethylene glycol dilauryl ester, polyethylene glycol nonylic acid ester, polyethylene glycol cetylic acid ester, polyethylene glycol stearoyl ester, polyethylene glycol distearoyl ester, polyethylene glycol behenic acid ester, polyethylene glycol dibehenic acid ester, polypropylene glycol acetyl ester, polypropylene glycol diacetyl ester, polypropylene glycol benzoic acid ester, polypropylene glycol dibenzoic acid ester, polypropylene glycol lauric acid ester, polypropylene glycol dilauric acid ester, polypropylene glycol nonylic acid ester, polyethylene glycol glycerin ether, polypropylene glycol glycerin ether, polyethylene glycol sorbitol ether, polypropylene glycol sorbitol ether, polyethylene glycolated ethylenediamine, polypropylene glycolated ethylenediamine, polyethylene glycolated diethylenetriamine, polypropylene glycolated diethylenetriamine and polyethylene glycolated pentamethylenehexamine.

The amount added of the polyethylene glycol-based compound is, in view of exerting a sufficiently high solubility inhibiting effect and maintaining good image forming property, preferably from 0.1 to 50 weight%, more preferably from 1 to 30 weight%, as the solid content based on the entire solid content amount of the image recording layer.

When the above-described measure for improving the inhibition (solubility inhibition) is applied, the sensitivity decreases. In this case, addition of a lactone compound is effective. The lactone compound is considered to react with the developer when the developer penetrates into the exposed part, and newly generate a carboxylic acid compound, thereby contributing to the dissolution of exposed part and enhancing the sensitivity.

The lactone compound is not particularly limited, but examples thereof include the compounds represented by the following formulae (L-I) and (L-II):

Formula (L-I):

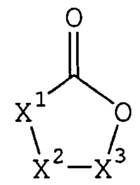

Formula (L-II):

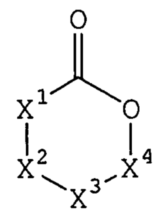

In formulae (L-I) and (L-II), $X^1$, $X^2$, $X^3$ and $X^4$, which may be the same or different, each represents a constituent atom or atomic group of the ring and each independently may have a substituent, and at least one of $X^1$, $X^2$ and $X^3$ in formula (L-I) and at least one of $X^1$, $X^2$, $X^3$ and $X^4$ in formula (L-II) have an electron-withdrawing substituent or a substituent substituted by an electron-withdrawing group.

The constituent atom or atomic group of the ring, represented by $X^1$, $X^2$, $X^3$ and $X^4$, is a nonmetallic atom having two single bonds for forming the ring or an atomic group containing the nonmetallic atom.

The nonmetallic atom or nonmetallic atom group is preferably an atom or atomic group selected from a methylene group, a sulfinyl group, a carbonyl group, a thiocarbonyl group, a sulfonyl group, a sulfur atom, an oxygen atom and a selenium atom, more preferably an atomic group selected from a methylene group, a carbonyl group and a sulfonyl group.

At least one of $X^1$, $X^2$ and $X^3$ in formula (L-I) or at least one of $X^1$, $X^2$, $X^3$ and $X^4$ in formula (L-II) has an electron-withdrawing group. The electron-withdrawing group as used in the present invention indicates a group where the Hammett's substituent constant σp takes a positive value. The Hammett's substituent constant is described, for example, in Journal of Medicinal Chemistry, Vol. 16, No. 11, 1207-1216 (1973). Examples of the electron-withdrawing group where the Hammett's substituent constant σp takes a positive value include halogen atoms (e.g., fluorine (σp value: 0.06), chlorine (σp value: 0.23), bromine (σp value: 0.23), iodine (σp value: 0.18)), trihaloalkyl groups (e.g., tribromomethyl (σp value: 0.29), trichloromethyl (σp value: 0.33), trifluoromethyl (σp value: 0.54)), a cyano group (σp value: 0.66), a nitro group (σp value: 0.78), aliphatic aryl or heterocyclic sulfonyl groups (e.g., methanesulfonyl (σp value: 0.72)), aliphatic aryl or heterocyclic acyl groups (e.g., acetyl (σp value: 0.50), benzoyl (σp value: 0.43)), alkynyl groups (e.g., C≡CH (σp value: 0.23)), aliphatic aryl or heterocyclic oxycarbonyl groups (e.g., methoxycarbonyl (σp value: 0.45), phenoxycarbonyl (σp value: 0.44)), a carbamoyl group (σp value: 0.36), a sulfamoyl group (σp value: 0.57), a sulfoxide group, a heterocyclic group, an oxo group and a phosphoryl group.

The electron-withdrawing group is preferably a group selected from an amide group, an azo group, a nitro group, a fluoroalkyl group having from 1 to 5 carbon atoms, a nitrile group, an alkoxycarbonyl group having from 1 to 5 carbon atoms, an acyl group having from 1 to 5 carbon atoms, an alkylsulfonyl group having from 1 to 9 carbon atoms, an arylsulfonyl group having from 6 to 9 carbon atoms, an alkylsulfinyl group having from 1 to 9 carbon atoms, an arylsulfinyl group having from 6 to 9 carbon atoms, an arylcarbonyl group having from 6 to 9 carbon atoms, a thiocarbonyl group, a fluorine-containing alkyl group having from 1 to 9 carbon atoms, a fluorine-containing aryl group having from 6 to 9 carbon atoms, a fluorine-containing allyl group having from 3 to 9 carbon atoms, an oxo group and halogen elements.

The electron-withdrawing group is more preferably a group selected from a nitro group, a fluoroalkyl group having from 1 to 5 carbon atoms, a nitrile group, an alkoxycarbonyl group having from 1 to 5 carbon atoms, an acyl group having from 1 to 5 carbon atoms, an arylsulfonyl group having from 6 to 9 carbon atoms, an arylcarbonyl group having from 6 to 9 carbon atoms, an oxo group and halogen elements.

Specific examples of the compounds represented by formulae (L-1) and (L-II) are set forth below, but the present invention is not limited to these compounds.

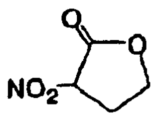
(LI-1)

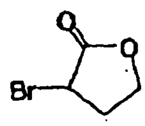
(LI-2)

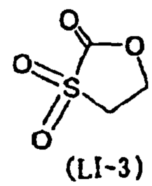
(LI-3)

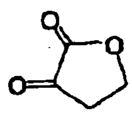
(LI-4)

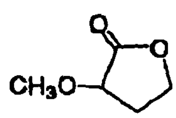
(LI-5)

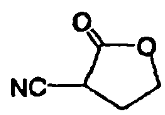
(LI-6)

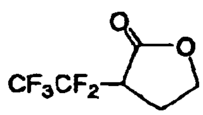
(LI-7)

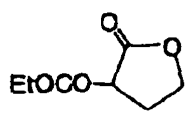
(LI-8)

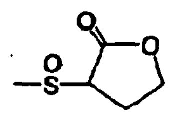
(LI-9)

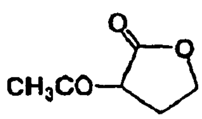
(LI-10)

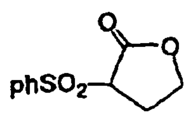
(LI-11)

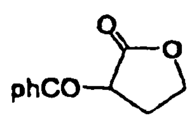
(LI-12)

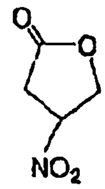

(LI-13)

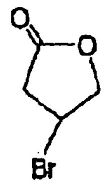

(LI-14)

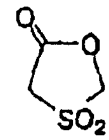

(LI-15)

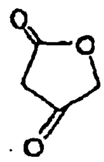

(LI-16)

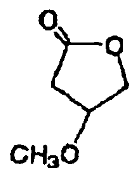

(LI-17)

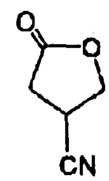

(LI-18)

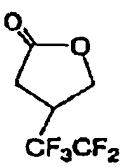

(LI-19)

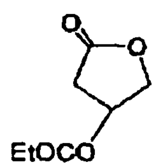

(LI-20)

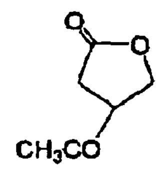

(LI-21)

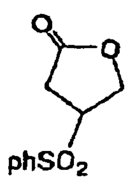

(LI-22)

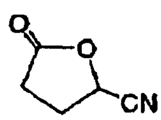

(LI-23)

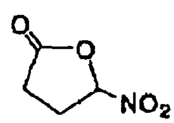

(LI-24)

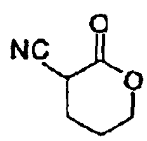

(LII-1)

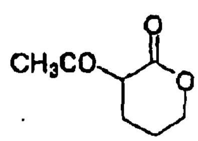

(LII-2)

The amount added of the compound represented by formula (L-I) or (L-II) is preferably from 0.1 to 50 weight%, more preferably from 1 to 30 weight%, as the solid content based on the entire solid content amount of the image recording layer. Incidentally, this compound reacts with the developer and therefore, it is preferred to selectively contact the compound with the developer.

One of these lactone compounds may be used alone or two or more thereof may be used in combination. Also, two or more compounds of formula (L-I) or two or more compounds of formula (L-II) may be used in combination

at an arbitrary ratio to give a total added amount within the above-described range.

Also, a thermally decomposable substance which, in the non-decomposed state, substantially decreases the solubility of an alkali water-soluble polymer compound, such as onium salt, o-quinonediazide compound, aromatic sulfone compound and aromatic sulfonic acid ester compound, is preferably used in combination from the standpoint of enhancing the solubility inhibition of the image part in the developer. Examples of the onium salt include diazonium salts, ammonium salts, phosphonium salts, iodonium salts, sulfonium salts, selenonium salts and arsonium salts.

Suitable examples of the onium salt for use in the present invention include diazonium salts described in S. I. Schlesinger, Photogr. Sci. Eng., 18, 387 (1974), T.S. Bal et al., Polymer, 21, 423 (1980), and JP-A-5-158230; ammonium salts described in U.S. Patents 4,069,055 and 4,069,056 and JP-A-3-140140; phosphonium salts described in D.C. Necker et al., Macromolecules, 17, 2468 (1984), C.S. Wen et al., The, Proc. Conf. Rad. Curing ASIA, p. 478, Tokyo (Oct., 1988), U.S. Patents 4,069,055 and 4,069,056; iodonium salts described in J. V. Crivello et al., Macromolecules, 10 (6), 1307 (1977), Chem. & Eng. News, Nov. 28, page 31 (1988), European Patent 104,143, U.S. Patents 339,049 and 410,201, JP-A-2-150848 and JP-A-2-296514; sulfonium salts described in J.V. Crivello et al., Polymer J., 17, 73 (1985), J.V. Crivello et al., J. Org. Chem., 43, 3055 (1978), W.R. Watt et al., J. Polymer Sci., Polymer Chem. Ed., 22, 1789 (1984), J.V. Crivello et al., Polymer Bull., 14, 279 (1985), J.V. Crivello et al., Macromolecules, 14 (5), 1141 (1981), J.V. Crivello et al., J. Polymer Sci., Polymer Chem. Ed., 17, 2877 (1979), European Patents 370,693, 233,567, 297,443 and 297,442, U.S. Patents 4,933,377, 3,902,114, 410,201, 339,049, 4,760,013, 4,734,444 and 2,833,827, and German Patents 2,904,626, 3,604,580 and 3,604,581; selenonium salts described in J.V. Crivello et al., Macromolecules, 10 (6), 1307 (1977) and J.V. Crivello et al., J. Polymer Sci., Polymer Chem. Ed., 17, 1047 (1979); and arsonium salts described in C.S. Wen et al., Teh. Proc. nf. Rad. Curing ASIA, p. 478, Tokyo (Oct., 1988).

Among the onium salts, diazonium salts are preferred. Particularly preferred examples of the diazonium salt include those described in JP-A-5-158230.

Examples of the counter ion for the onium salt include tetrafluoroboric acid, hexafluorophosphoric acid, triisopropylnaphthalenesulfonic acid, 5-nitro-o-toluenesulfonic acid, 5-sulfosalicylic acid, 2,5-dimethylbenzenesulfonic acid, 2,4,6-trimethylbenzenesulfonic acid, 2-nitrobenzenesulfonic acid, 3-chlorobenzenesulfonic acid, 3-bromobenzenesulfonic acid, 2-fluorocaprylnaphthalenesulfonic acid, dodecylbenzenesulfonic acid, 1-naphthol-5-sulfonic acid, 2-methoxy-4-hydroxy-5-benzoyl-benzenesulfonic acid and p-toluenesulfonic acid. Among these, preferred are hexafluorophosphoric acid and alkyl aromatic sulfonic acids such as triisopropylnaphthalenesulfonic acid and 2,5-dimethylbenzenesulfonic acid.

Suitable examples of the quinonediazides include o-quinonediazide compounds. The o-quinonediazide compound for use in the present invention is a compound having at least one o-quinonediazide group and capable of increasing the alkali-solubility through thermal decomposition, and compounds having various structures can be used. That is, upon thermal decomposition, the o-quinonediazide loses the ability of inhibiting the dissolution of binder and the o-quinonediazide itself is converted into an alkali-soluble substance. By virtue of these two effects, the solubility of the photosensitive system is improved. Examples of the o-quinonediazide compound usable in the present invention include compounds described in J. Coaser, Light-Sensitive Systems, John Wiley & Sons Inc., pp. 339-352, and in particular, sulfonic acid esters or sulfonic acid amides of o-quinonediazide, obtained by the reaction with various aromatic polyhydroxy compounds or aromatic amino compounds, are preferred. In addition, esters of benzoquinone-(1,2)-diazidesulfonic acid chloride or naphthoquinone-(1,2)-diazide-5-sulfonic acid chloride with pyrogallol-acetone resin described in JP-B-43-28403, and esters of benzoquinone-(1,2)-diazidesulfonic acid chloride or naphthoquinone-(1,2)-diazide-5-sulfonic acid chloride disclosed with phenol-formaldehyde resin described in U.S. Patents 3,046,120 and 3,188,210, may also be suitably used.

Furthermore, esters of naphthoquinone-(1,2)-diazide-4-sulfonic acid chloride with phenol-formaldehyde resin or cresol-formaldehyde resin, and esters of naphthoquinone-(1,2)-diazide-4-sulfonic acid chloride with pyrogallol-acetone resin may also be suitably used. Other useful examples of the o-quinonediazide compound include those described in a large number of patent publications such as JP-A-47-5303, JP-A-48-63802, JP-A-48-63803, JP-A-48-96575, JP-A-49-38701 and JP-A-48-13354, JP-B-41-11222, JP-B-45-9610 and JP-B-49-17481, U.S. Patents 2,797,213, 3,454,400, 3,544,323, 3,573,917, 3,674,495 and 3,785,825, British Patents 1,227,602, 1,251,345, 1,267,005, 1,329,888 and 1,330,932, and German Patent 854,890.

The amount added of the o-quinonediazide compound is preferably from 1 to 50 weight%, more preferably from 5 to 30 weight%, still more preferably from 10 to 30 weight%, based on the entire solid content in the image recording layer. One of these compounds may be used alone, or several species thereof may be used as a mixture.

Also, at least partially esterified alkali-soluble resin described in JP-A-11-288089 may be contained.

Furthermore, for the purpose of enhancing the dissolution inhibiting property of the image recording layer surface and elevating the resistance against scratches on the surface, it is preferred to use in combination a polymer comprising, as a polymerization component, a (meth)acrylate monomer containing two or three perfluoroalkyl groups having from 3 to 20 carbon atoms within the molecule described in JP-A-2000-187318. As for the amount added, the ratio of the polymer occupying in the entire solid content of the image recording layer is preferably from 0.1 to 10

weight%, more preferably from 0.5 to 5 weight%.

-Development Accelerator-

In order to more elevate the sensitivity, acid anhydrides, phenols or organic acids may also be used in combination.

The acid anhydrides are preferably a cyclic acid anhydride, and specific examples of the cyclic acid anhydride which can be used include phthalic anhydride, tetrahydrophthalic anhydride, hexahydrophthalic anhydride, 3,6-endooxytetrahydrophthalic anhydride, tetrachlorophthalic anhydride, maleic anhydride, chloromaleic anhydride, $\alpha$-phenylmaleic anhydride, succinic anhydride and pyromellitic anhydride described in U.S. Patent 4,115,128. The example of the non-cyclic acid anhydride includes acetic anhydride.

Examples of the phenols include bisphenol A, 2,2'-bishydroxysulfone, p-nitrophenol, p-ethoxyphenol, 2,4,4'-trihydroxybenzophenone, 2,3,4-trihydroxybenzophenone, 4-hydroxybenzophenone, 4,4',4"-trihydroxytriphenylmethane and 4,4',3",4"-tetrahydroxy-3,5,3',5'-tetramethyltriphenylmethane.

Examples of the organic acids include sulfonic acids, sulfinic acids, alkylsulfuric acids, phosphonic acids, phosphoric acid esters and carboxylic acids described in JP-A-60-88942 and JP-A-2-96755. Specific examples thereof include p-toluenesulfonic acid, dodecylbenzenesulfonic acid, p-toluenesulfinic acid, ethylsulfuric acid, phenylphosphonic acid, phenylphosphinic acid, phenyl phosphate, diphenyl phosphate, benzoic acid, isophthalic acid, adipic acid, p-toluic acid, 3,4-dimethoxybenzoic acid, phthalic acid, terephthalic acid, 4-cyclohexene-1,2-dicarboxylic acid, erucic acid, lauric acid, n-undecanoic acid and ascorbic acid.

The ratio of such acid anhydrides, phenols and organic acids occupying in the image recording layer is preferably from 0.05 to 20 weight%, more preferably from 0.1 to 15 weight%, still more preferably from 0.1 to 10 weight%.

-Surfactant-

In the image recording layer, nonionic surfactants described in JP-A-62-251740 and JP-A-3-208514, amphoteric surfactants described in JP-A-59-121044 and JP-A-4-13149, siloxane-based compounds described in EP-950517, and copolymers of fluorine-containing monomer described in JP-A-62-170950, JP-A-11-288093 and Japanese Patent Application No. 2001-247351 may be added so as to enhance the coatability and broaden the stability of processing against the development conditions.

Specific examples of the nonionic surfactant include sorbitan tristearate, sorbitan monopalmitate, sorbitan trioleate, stearic acid monoglyceride and polyoxyethylene nonyl phenyl ether. Specific examples of the amphoteric surfactant include alkyldi(aminoethyl)glycine, alkylpolyaminoethylglycine hydrochloride, 2-alkyl-N-carboxyethyl-N-hydroxyethylimidazolinium betaine and N-tetradecyl-N,N-betaine type surfactant (for example, "Amorgen K" (trade name) produced by Dai-ichi Kogyo Seiyaku Co., Ltd.).

The siloxane-based compound is preferably a block copolymer of dimethylsiloxane and polyalkylene oxide, and specific examples thereof include polyalkylene oxide-modified silicones such as DBE-224, DBE-621, DBE-712, DBP-732 and DBP-534 produced by Chisso Corporation, and Tego Glide 100 produced by Tego in Germany.

The ratio of the nonionic or amphoteric surfactant occupying in the entire solid content of the image-forming layer is preferably from 0.01 to 15 weight%, more preferably from 0.1 to 5 weight%, still more preferably from 0.05 to 0.5 weight%.

-Printing Out Agent/Coloring Agent-

In the image recording layer, a printing out agent for obtaining a visible image immediately after heating by exposure, or a dye or pigment as the image coloring agent can be added.

A representative example of the printing out agent is a combination of a compound capable of releasing an acid under heating by exposure with an organic dye capable of forming a salt. Specific examples thereof include a combination of o-naphthoquinonediazide-4-sulfonic acid halogenide with salt-forming organic dye described in JP-A-50-36209 and JP-A-53-8128, and a combination of trihalomethyl compound with salt-forming organic dye described in JP-A-53-36223, JP-A-54-74728, JP-A-60-3626, JP-A-61-143748, JP-A-61-151644 and JP-A-63-58440. This trihalomethyl compound includes an oxazole-based compound and a triazine-based compound, which are both excellent in the aging stability and give a clear printed-out image.

As for the image coloring agent, dyes other than the above-described salt-forming organic dyes may also be used. Suitable dyes include oil-soluble dyes and basic dyes, including the salt-forming organic dyes. Specific examples thereof include Oil Yellow #101, Oil Yellow #103, Oil Pink #312, Oil Green BG, Oil Blue BOS, Oil Blue #603, Oil Black BY, Oil Black BS, Oil Black T-505 (all produced by Orient Kagaku Kogyo Co., Ltd.), Victoria Pure Blue, Crystal Violet Lactone, Crystal Violet (CI 42555), Methyl Violet (CI 42535), Ethyl Violet, Rhodamine B (CI 145170B), Malachite Green

(CI 42000) and Methylene Blue (CI 52015). Dyes described in JP-A-62-293247 are particularly preferred.
Such a dye can be added in a ratio of 0.01 to 10 weight%, preferably from 0.1 to 3 weight%, based on the entire solid content in the image recording layer.

-Plasticizer-

In the image recording layer, a plasticizer is further added, if desired, so as to impart flexibility or the like to the coated film. Examples of the plasticizer include butyl phthalyl, polyethylene glycol, tributyl citrate, diethyl phthalate, dibutyl phthalate, dihexyl phthalate, dioctyl phthalate, tricresyl phosphate, tributyl phosphate, trioctyl phosphate, tetrahydrofurfuryl oleate, and oligomers or polymers of acrylic acid or methacrylic acid.

-Wax Agent-

In the image recording layer of the lithographic printing plate precursor, a compound of decreasing the coefficient of static friction on surface may be added so as to impart resistance against scratches. Specific examples of the wax agent include compounds having an ester of long-chain alkylcarboxylic acid described in U.S. Patent 6,117,913 and Japanese Patent Application Nos. 2001-261627, 2002-032904 and 2002-165584. As for the amount added, the ratio of the wax agent occupying in the entire solid content constituting the layer is preferably from 0.1 to 10 weight%, more preferably from 0.5 to 5 weight%.
The lithographic printing plate precursor can be usually produced by dissolving a heat-sensitive composition containing the above-described components in a solvent and coating the resulting solution on an appropriate support.

Coating Solvent

Examples of the solvent used here include, but are not limited to, ethylene dichloride, cyclohexanone, methyl ethyl ketone, methanol, ethanol, propanol, ethylene glycol monomethyl ether, 1-methoxy-2-propanol, 2-methoxyethyl acetate, 1-methoxy-2-propyl acetate, dimethoxyethane, methyl lactate, ethyl lactate, N,N-dimethylacetamide, N,N-dimethylformamide, N-methylpyrrolidone, tetramethylurea, N-methylpyrrolidone, dimethyl sulfoxide, sulfolane, γ-butyrolactone, toluene and water. These solvents are used individually or as a mixture.
In selecting the coating solvent, in the case of having a two-layer structure of upper recording layer and lower recording layer, the coating solvent for the upper recording layer is preferably selected from those of substantially not dissolving the lower recording layer, so that when these layers are adjacently provided, the layers can be prevented from being compatibilized at their interface. The concentration of the above-described components (entire solid content including additives) in the solvent is preferably from 1 to 50 weight%.
In the case of using an acid anhydride, the water in the coating solution is preferably set to 0.5% or less.

Coated Amount

The coated amount (solid content) of the heat-sensitive composition varies depending on use but in view of film properties and press life, this composition can be provided in a coated amount of 0.3 to 3.0 $g/m^2$, preferably from 0.5 to 2.5 $g/m^2$, more preferably from 0.8 to 1.6 $g/m^2$.

Multilayer Structure

In the lithographic printing plate precursor for use in the present invention, an image recording layer containing the above-described components is provided on a support. This image recording layer may have a multilayer structure of at least two or more layers (hereinafter, for the convenience's sake, the case having a two-layer structure consisting of an upper side layer and a lower side layer is described).
In this case, the alkali-soluble resin constituting the upper side layer and the lower side layer may be an alkali-soluble resin described above, but the alkali-soluble resin used for the upper side layer preferably has a lower solubility in alkali than that of the lower side layer.
The infrared absorbing dye may be different infrared absorbing dyes among respective layers, or an infrared absorbing dye comprising a plurality of compounds may be used for each layer. In which layer the dye is used, as described above, the dye can be added in a ratio of 0.01 to 50 weight%, preferably from 0.1 to 50 weight%, more preferably from 0.1 to 30 weight%, based on the entire solid content of the layer to which the dye is added. In the case of adding the dye to a plurality of layers, the infrared absorbing dyes are preferably added to give a total added amount falling within this range.
The above-described thermally decomposable substance which, in the non-decomposed state, substantially

decreases the solubility of the alkali water-soluble resin may partially decompose in aging and therefore, in the case of an image recording layer having a multilayer structure, it may be effective to incorporate this substance into the lower side layer, but the substance can be added in either layer or in both layers. The amount of the substance contained is as described above. In the case of adding this substance to a plurality of layers, the substances are preferably added to give a total added amount falling within the range described above.

The lactone compound may be added in either layer or in both layers, though in the case of a multilayer structure, it is effective to incorporate the lactone compound into the upper side layer.

Support

The hydrophilic support for use in the lithographic printing plate precursor is, for example, a dimensionally stable plate-like material with necessary strength and durability. Examples thereof include paper, paper laminated with plastic (e.g., polyethylene, polypropylene, polystyrene), metal plate (e.g., aluminum, zinc, copper), plastic film (e.g., cellulose diacetate, cellulose triacetate, cellulose propionate, cellulose butyrate, cellulose acetate butyrate, cellulose nitrate, polyethylene terephthalate, polyethylene, polystyrene, polypropylene, polycarbonate, polyvinyl acetal), and paper or plastic film laminated or vapor-deposited with the above-described metal.

Among these supports, polyester film and aluminum plate are preferred, and aluminum plate is more preferred because this is dimensionally stable and relatively inexpensive. The aluminum plate is preferably a pure aluminum plate or an alloy plate mainly comprising aluminum and containing trace heteroelements. A plastic film laminated or vapor-deposited with aluminum may also be used.

Examples of the heteroelement contained in the aluminum alloy include silicon, iron, manganese, copper, magnesium, chromium, zinc, bismuth, nickel and titanium. The heteroelement content in the alloy is 10 weight% or less at most.

The particularly preferred aluminum is pure aluminum, but completely pure aluminum is difficult to produce in view of refining technique and therefore, an aluminum plate containing trace heteroelements may be used. Such an aluminum plate is not particularly limited in its composition, and a related art material can be appropriately used. The thickness of the aluminum plate for use in the present invention is approximately from 0.1 to 0.6 mm, preferably from 0.15 to 0.4 mm, more preferably from 0.2 to 0.3 mm.

In advance of surface-roughening the aluminum plate, a degreasing treatment for removing the rolling oil on the surface is performed, if desired, by using a surfactant, an organic solvent, an alkaline aqueous solution or the like. The surface-roughening treatment of the aluminum plate surface is performed by various methods, for example, by a mechanical surface-roughening method, a surface-roughening method of electrochemically dissolving the surface, or a surface-roughening method of chemically and selectively dissolving the surface. As for the mechanical method, a related art method such as ball polishing, brush polishing, blast polishing and buff polishing may be used. As for the electrochemical surface-roughening method, a method of passing an alternating or direct current in an electrolytic solution of hydrochloric acid or nitric acid may be used. Also, a method using a combination of these two methods disclosed in JP-A-54-63902 may be employed.

The surface-roughened aluminum plate is subjected to an alkali etching treatment and a neutralization treatment, if desired, and then subjected to an anodization treatment, if desired, so as to enhance the water retentivity and abrasion resistance of the surface. As for the electrolyte used in the anodization treatment of aluminum plate, various electrolytes of forming a porous oxide film may be used. In general, sulfuric acid, phosphoric acid, oxalic acid, chromic acid or a mixed acid thereof is used. The concentration of the electrolyte is appropriately determined according to the kind of electrolyte.

The anodization treatment conditions vary depending on the electrolyte used and therefore, cannot be indiscriminately specified, but in general, the conditions are suitably such that the concentration of electrolyte is from 1 to 80 weight%, the liquid temperature is from 5 to 70°C, the current density is from 5 to 60 A/dm$^2$, the voltage is from 1 to 100 V, and the electrolysis time is from 10 seconds to 5 minutes. The amount of the anodic oxide film formed is preferably 1.0 g/m$^2$ or more in view of press life. After the anodization treatment, the aluminum surface is subjected to a hydrophilization treatment, if desired. As for the hydrophilization treatment, an alkali metal silicate (for example, aqueous sodium silicate solution) method disclosed in U.S. Patents 2,714,066, 3,181,461, 3,280,734 and 3,902,734 is related. In this method, the support is dipped or electrolyzed in an aqueous sodium silicate solution. Other examples include a method of treating the support with potassium fluorozirconate disclosed in JP-B-36-22063 or with polyvinylphosphonic acid disclosed in U.S. Patents 3,276,868, 4,153,461 and 4,689,272.

In the lithographic printing plate precursor for use in the present invention, at least the above-described image recording layer is provided on a support, but if desired, an undercoat layer may be provided between the support and the image recording layer.

As for the component of the undercoat layer, various organic compounds are used and the organic compound is, for example, selected from carboxymethyl cellulose; dextrin; gum arabic; amino group-containing phosphonic acids

such as 2-aminoethylphosphonic acid; organic phosphonic acids, which may have a substituent, such as phenylphosphonic acid, naphthylphosphonic acid, alkylphosphonic acid, glycerophosphonic acid, methylenediphosphonic acid and ethylenediphosphonic acid; organic phosphoric acids, which may have a substituent, such as phenylphosphoric acid, naphthylphosphoric acid, alkylphosphoric acid and glycerophosphoric acid; organic phosphinic acids, which may have a substituent, such as phenylphosphinic acid, naphthylphosphinic acid, alkylphosphinic acid and glycerophosphinic acid; amino acids such as glycine and β-alanine; and hydrochlorides of hydroxyl group-containing amine, such as hydrochloride of triethanolamine. These organic compounds may be used as a mixture of two or more thereof.

Also, an undercoat layer containing at least one compound selected from the organic polymer compound group having a structural unit represented by the following formula is preferred.

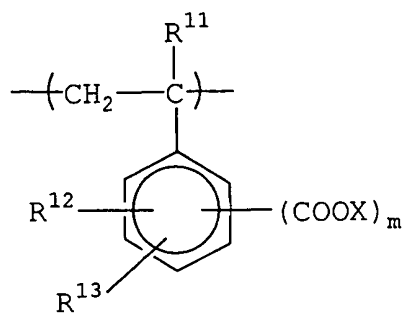

wherein $R^{11}$ represents a hydrogen atom, a halogen atom or an alkyl group, $R^{12}$ and $R^{13}$ each independently represents a hydrogen atom, a hydroxyl group, a halogen atom, an alkyl group, a substituted alkyl group, an aryl group, a substituted aryl group, $-OR^{14}$, $-COOR^{15}$, $-CONHR^{16}$, $-COR^{17}$ or -CN or $R^{12}$ and $R^{13}$ may combine to form a ring, $R^{14}$ to $R^{17}$ each independently represents an alkyl group or an aryl group, X represents a hydrogen atom, a metal atom or $NR^{18}R^{19}R^{20}R^{21}$, $R^{18}$ to $R^{21}$ each independently represents a hydrogen atom, an alkyl group, a substituted alkyl group, an aryl group or a substituted aryl group or $R^{18}$ and $R^{19}$ may combine to form a ring, and m represents an integer of 1 to 3.

The undercoat layer can be provided by the following method. That is, the undercoat layer can be provided by a method where the organic compound is dissolved in water, an organic solvent such as methanol, ethanol or methyl ethyl ketone, or a mixed solvent thereof and the resulting solution is coated on an aluminum plate and then dried, or a method where an aluminum plate is dipped in a solution resulting from dissolving the organic compound in water, an organic solvent such as methanol, ethanol or methyl ethyl ketone, or a mixed solvent thereof, allowed to adsorb the compound, then washed with water or the like and dried. In the former method, a solution containing the organic compound at a concentration of 0.005 to 10 weight% can be coated by various methods. In the latter method, the concentration of the solution is from 0.01 to 20 weight%, preferably from 0.05 to 5 weight%, the dipping temperature is from 20 to 90°C, preferably 25 to 50°C, and the dipping time is from 0.1 second to 20 minutes, preferably from 2 seconds to 1 minute. The solution used therefor may be adjusted to a pH of 1 to 12 by using a basic substance such as ammonia, triethylamine or potassium hydroxide, or an acidic substance such as hydrochloric acid or phosphoric acid.

The coverage of the undercoat layer is, in view of press life performance, suitably from 2 to 200 $mg/m^2$, preferably from 5 to 100 $mg/m^2$.

The thus-prepared lithographic printing plate precursor is imagewise exposed and then developed by using an alkali developing solution which is described in detail above.

Examples of the light source for actinic rays used for the imagewise exposure include mercury lamp, metal halide lamp, xenon lamp, chemical lamp and carbon arc lamp. Examples of the radiation include electron beam, X-ray, ion beam and far infrared ray. Also, g-line, i-line, Deep-UV light and high-density energy beam (laser beam) may be used. Examples of the laser beam include helium·neon laser, argon laser, krypton laser, helium·cadmium laser and KrF excimer laser. In the present invention, a light source having a light emission wavelength in the region from near infrared to infrared is preferred, and a solid laser and a semiconductor laser are more preferred.

In the case where an unnecessary image part is present on the lithographic printing plate obtained through image exposure, development, and water washing and/or rinsing and/or gumming, the unnecessary image part is erased. This erasure is preferably performed by a method described in JP-B-2-13293, where an erasing solution is coated on the unnecessary image part, left standing as-is for a predetermined time and then washed with water, but may also be performed by a method described in JP-A-59-174842, where the unnecessary image part is irradiated with active rays guided by an optical fiber and then developed.

The lithographic printing plate obtained in this way by the plate-making method of the present invention is coated with a desensitizing gum, if desired, and then can be used for printing, but in the case of imparting higher impression capacity to the lithographic printing plate, a burning treatment is applied. In performing the burning treatment, the lithographic printing plate before burning is preferably treated with a surface-adjusting solution described in JP-B-61-2518, JP-B-55-28062, JP-A-1-31859 and JP-A-61-159655.

With respect to the method therefor, the surface-adjusting solution is coated on the lithographic printing plate by using a sponge or absorbent cotton impregnated with the solution or by dipping the printing plate in a vat filled with a surface-adjusting solution, or the surface-adjusting solution is coated by an automatic coater. When the coated amount is homogenized by using a squeegee or squeegee roller after coating, this gives more advantageous results.

In general, the coated amount of the surface-adjusting solution is suitably from 0.03 to 0.8 $g/m^2$ (dry weight). The lithographic printing plate coated with the surface-adjusting solution is dried, if desired, and then heated at a high temperature by using a burning processor (for example, Burning Processor BP-1300 available from Fuji Photo Film Co., Ltd.). In this case, the heating temperature and heating time vary depending on the kind of components constituting the image but are preferably from 180 to 300°C and from 1 to 20 minutes, respectively.

The lithographic printing plate after the burning treatment may be appropriately subjected to, if desired, related art treatments such as water washing and gumming, but when the surface-adjusting solution used contains a water-soluble polymer compound or the like, a so-called desensitizing treatment such as gumming can be omitted. The lithographic printing plate obtained through such treatments is mounted on an offset printing press and then used for printing a large number of sheets.

The present invention is described below by referring to the embodiments shown in the drawings. Fig. 1 is a constitutional view showing a first embodiment of the automatic developing apparatus used for practicing the development replenishment method according to the present invention. As shown in Fig. 1, the automatic developing apparatus 2 comprises a developing unit 6 for developing a photosensitive lithographic printing plate (hereinafter referred to as "PS plate") 4, an after-processing unit 8 for washing off the developer adhered to the developed PS plate 4 and also coating a gum solution thereon, and a drying unit 10 for drying the PS plate coated with the gum solution.

In the case of processing a PS plate which requires heating prior to the development processing, a preheating unit (not shown in Fig. 1) may be provided. The preheating unit is disposed on the upstream side of the developing unit 6 in the transport direction and imparted with a function of keeping a predetermined PS plate surface temperature for a predetermined period of time as the PS plate is transported. The PS plate inserted into the preheating unit is automatically transported to the next step while being heated. The developing apparatus may also comprise a pre-washing unit (not shown in Fig. 1). The pre-washing unit is disposed on the upstream side of the developing unit 6 in the transport direction and at the same time, on the downstream side of the preheating unit in the transport direction, and is imparted with a function of washing and cooling the PS plate surface with washing water as the PS plate is transported. The PS plate inserted into the pre-washing unit is automatically transported to the next step, that is, the developing unit 6.

An insert port 14 is formed in a side board 12 of the automatic developing apparatus 2, and the PS plate 4 inserted from the insert port 14 is transported to the developing unit 6 by transport rollers 16. At the insert port 14, a rubber blade 18 is provided and when a PS plate 4 is not inserted, the insert port 14 is closed by the rubber blade 18.

Within a developing tank 20 of the developing unit 6, transport rollers 22, brush rollers 24 and squeeze rollers 26 are sequentially provided from the upstream side in the transport direction, and backup rollers 28 are also provided at appropriate positions between those rollers. As the plate is transported by the transport rollers 22, the PS plate 4 is dipped in the developer and thereby developed.

The after-processing unit 8 continuing to the developing unit 6 comprises a washing unit 8a and a finisher unit 8b. In the washing unit 8a, rollers 30a' and 30a for transporting the PS plate 4, a washing tank 32a, and nozzle members 34a for spraying the washing solution in 32a onto the PS plate 4 are provided. Also, a washing water supply pump 78a for supplying washing water to the washing tank 32a is provided. In the finisher unit 8b, rollers 30b for transporting the PS plate 4, a finisher tank 32b, and nozzle members 34b for spraying the finisher solution in 32b onto the PS plate 4 are provided. Also, a gum solution supply pump 77 for supplying the gum solution to the finisher tank 32b, and a gum solution diluent supply pump 78b for supplying a gum solution diluent are provided. The developed PS plate 4 is washed with a washing solution sprayed from the ejection member 34a as it is transported by the transport rollers 30a, and thereafter coated with a finisher solution sprayed from the ejection member 34b as the PS plate 4 is transported by transport rollers 30b.

At this time, the diluent 57 in the replenisher diluent tank 57 is replenished to the washing tank 32a by the washing water supply pump 78a. In the finisher tank 32b, the gum solution in the gum solution tank 56 is replenished by the pump 77 and at the same time, the diluent 57 in the replenisher diluent storage tank 53 is replenished by the replenisher diluent supply pump 78b. Here, the replenishment ratio between the gum solution and the diluent is, for example, 1:1. Along with such replenishment, the washing solution overflowed from the washing tank 32a and the gum waste solution overflowed from the finisher tank 32b are recovered in the waste solution tank 54 similarly to the development waste solution.

It is also effective to provide a washing brush roller (not shown in Fig. 1) in the washing unit 8a. This washing brush roller is disposed between the nozzle member 34a and the PS plate 4 to abut against the top surface or top and

bottom surfaces of the PS plate 4, and while rotating, rubs and thereby washes the surface of PS plate 4 under transportation.

On the other hand, a structure where the washing part 8a works as a first finisher unit 8a and the finisher unit 8b works as the second finisher unit 8b is also effective. In the first finisher unit 8a and second finisher unit 8b, transport rollers 30a and 30b for transporting the PS plate 4 and nozzle members 34a and 34b for spraying the gum solution in finisher tanks 32a and 32b onto the PS plate 4 are provided. The PS plate 4 after the development is coated with the gum solution sprayed by the nozzle members 34a and 34b as it is transported by the transport rollers 30a and 30b. At this time, the gum solution in the finisher tank 32b of the second finisher unit 8b located on the downstream side is overflowed and thereby supplied to the finisher tank 32a of the first finisher unit 8a located on the upstream side, but in stead of such a constitution, the gum solution may be similarly supplied by using a pump or the like. In this case, the washing water supply pump 78a is not used.

In the second finisher tank 32b, the gum solution in the gum solution tank 56 is replenished by the pump 77 and at the same time, the diluent 57 in the replenisher diluent storage tank 53 is replenished by the replenisher diluent supply pump 78. Here, the replenishment ratio between the gum solution and the diluent is, for example, 1:1. Along with such replenishment, the gum waste solution overflowed from the first finisher tank 32a is recovered in the waste solution tank 54 similarly to the development waste solution.

In the drying unit 10 continuing to the finisher unit 8, a guide roller 36 and a pair of skewer rollers 38 are sequentially provided from the upstream side in the transport direction. Also, in the drying unit 10, a drying device (not shown) such as warm-air supply device or heating device is provided. A discharge port 40 is provided in the drying unit 10 and the PS plate 4 dried by the drying device is discharged from the discharge port 40. Furthermore, a shutter 44 is provided in a passage between the drying unit 10 and the finisher unit 8 and when the PS plate 4 is not passing through the passage 46, the passage 46 is closed by the shutter 44.

In a developing tank 20, a box-shaped shielding cover 60 is provided integrally with the tank wall. The bottom wall of the shielding cover 60 is structured to have curved depressions so as not to contact with upper circumferential surfaces of the transport roller 22, brush roller 24 and backup roller 28, and thereby prevented from interference with rollers or the like. By virtue of the box shape of the shielding cover 60, an airtight space is formed above the developing tank 20 and this provides an effect of minimizing the amount of air in the developing unit 6. Furthermore, owing to the presence of the shielding cover 60, the area of the developer contacting with air is made as small as possible.

In the automatic developing apparatus 2 having the above-described construction, rubber blades 62 are provided at proper positions to construct a substantially airtight space from the developing unit 6 to the finisher unit 8b, whereby external air is prevented from entering. The space between the developing unit 6 and the washing unit 8a is also made substantially airtight by a rubber blade 62 and the air in the washing unit 8a is prevented from flowing into the developing unit 6. Accordingly, the developing unit 6 is substantially airtight and established to have a closed construction allowing for almost no inflow of air, though air slightly enters at the passage of PS plate 4.

The developing unit 6 is described in detail below. The developing tank 20 is connected with a circulation pipe 80 for the developer. In the circulation pipe 80, a developer circulation pump 71, an electric conductivity sensor 73 and a filter (not shown) are provided. The developer in the developing tank 20 is sucked into the circulation pipe 80 by the developer circulation pump 71 through the suction hole provided in the bottom of the developing tank 20, circulated in the circulation pipe 80 and again discharged into the developing tank 20. The filter filters the developer flowing in the circulation pipe 80. The electric conductivity sensor 73 measures the electric conductivity of the developer flowing in the circulation pipe 80.

Also, in the developing unit 6, members constituting a replenishment device, that is, replenisher pipes 90 and 91, a replenisher stock solution storage tank 55 connected to the replenisher pipe 90, a replenisher stock solution supply pump 74 intervened in the replenisher pipe 90, a replenisher diluent storage tank 53 connected to the replenisher pipe 91, and a replenisher diluent supply pump 76 intervened in the replenisher pipe 91, are provided and these function as a replenisher supply device. The development waste solution overflowed from the developing tank 20 is recovered in the waste solution tank 54.

More specifically, a pair of replenisher pipes 90 and 91 for the development replenisher obtained by diluting the development replenisher stock solution 58 with the replenisher diluent 57 are provided in the vicinity of the developing tank 20. The replenisher pipe 90 for the development replenisher stock solution 58 is connected to the replenisher stock solution storage tank 55 at the another end (bottom in Fig. 1), and in the pipe, a replenisher stock solution supply pump 74 is provided. The replenisher stock solution supply pump 74 supplies the development replenisher stock solution 58 to the developing tank 20 from the replenisher stock solution storage tank 55. The replenisher pipe 91 for the replenisher diluent 57 is connected to the replenisher diluent storage tank 53 at another end (bottom in Fig. 1), and in the pipe, a replenisher diluent supply pump 76 is provided. The replenisher diluent supply pump 76 supplies the replenisher diluent (water) 57 to the developing tank 20 from the replenisher diluent storage tank 53. In other words, a diluent replenishment device is constituted by the replenisher pipe 91, the replenisher diluent supply pump 76 and the replenisher diluent storage tank 53.

The replenisher stock solution supply pump 74 and the replenisher diluent supply pump 76 are controlled by a control device (controlling means) 50 comprising a controlling ROM 51a or controlling RAM 51b as a condition memorizing device and a time measuring unit 52, based on signals from the electric conductivity sensor 73 and the time measuring unit 52. Also, the control device 50 processes the transportation of PS plates by driving transport rollers 22, brush rollers 24, squeeze rollers 26 and the like at proper timing based on signals from the plate detection sensor 27.
Furthermore, in the control device 50, the elapsed time from the last integration of aging replenishment and the elapsed time from the last measurement of electric conductivity are measured by the time measuring unit 52, and the electric conductivity of developer is measured by the electric conductivity sensor 73. By using these measured values and, if desired, at a previously determined replenishment amount·replenisher dilution ratio, the control device 50 supplies the development replenisher (development replenisher stock solution 58 + replenisher diluent 57) to the developing tank 20 from the replenisher stock solution storage tank 55 and the replenisher diluent storage tank 53.
The control by the control device 50 is described below. Figs. 2, 3, 4, 5 and 6 each is an example of the flow chart showing the control system by the control device 50. By these control systems, replenishment with a proper replenishment amount can be performed even when changes are caused in the processing conditions such as plate species, plate size and processing frequency.
A fundamental control processing of replenishing the development replenisher is described below by referring to Fig. 2.
At step 1 (hereinafter simply referred to as "S1"), the electric conductivity value of developer of giving a proper developer activity experimentally determined in advance is set as the electric conductivity reference value: $d_T$. Then, at S2, whether the elapsed time from start-up or last measurement of the electric conductivity of developer reaches a previously determined time is judged, and the operation advances to S3 when reached or advances to S6 when not reached. At S3, the electric conductivity of developer is measured. At S4, the measured electric conductivity value of developer is compared with the electric conductivity reference value and the operation advances to S5 when the electric conductivity value of developer is smaller than the electric conductivity reference value, otherwise advances to S6.
At S5, the replenisher in a previously determined amount is replenished to the developer, and the operation advances to S6.
At S6, the state of the operation switch for the automatic developer is checked, and the operation returns to S2 when the operation switch is turned on or the processing is terminated due to stopping of the apparatus when the operation switch is turned off.
The first control processing of which fundamental control processing is specifically shown above is described below by referring to Fig. 3.
At S11, the throughput integrated value: Is which is a variable used during control, is initialized, that is, 0 is assigned.
At S12, when the processing is performed, the processed area is integrated to Is and then at S 13, the electric conductivity reference value: $d_T$ is calculated from this Is according to an arithmetic expression. The arithmetic expression used here is preferably, for example, the following formula:
Arithmetic Expression 1:

$$d_T=(D_M-D_L)\times EXP(-C_1\times I_S)+D_L$$

(wherein $D_M$, $D_L$ and $C_1$ are constants experimentally determined in advance, and $EXP(x)=e^x$).
At S14, whether the elapsed time from start-up or last measurement of the electric conductivity of developer reaches a previously determined time is judged, and the operation advances to S 15 when reached or advances to S 18 when not reached.
At S 15, the electric conductivity of developer is measured and the measured value is assigned to a variable: $d_M$. Then, at S16, this $d_M$ is compared with $d_T$, and the operation advances to S 17 when $d_M$ is smaller or advances to S18 when $d_M$ is larger. At S17, the replenisher in a previously determined amount is replenished to the developer.
At S 18, the state of the operation switch for the automatic developer is checked, and the operation returns to S12 when the operation switch is turned on or the processing is terminated due to stopping of the apparatus when the operation switch is turned off.
In this way, the electric conductivity target value is sequentially calculated every time the development replenisher is replenished, by using a throughput integrated value which is an integrated processed area during a development, so that despite a simple and inexpensive construction of the developing unit of the automatic developing machine, the fluctuation of developer sensitivity due to change in the processing conditions of development with a developer containing an electrolyte can be minimized.
The second control processing is described below by referring to Fig. 4.
At S21, whether this automatic developing apparatus is first started or not is judged and when first started,

the replenisher replacement ratio: X which is a variable used during control, is initialized, that is, 0 is assigned.

At S22, the electric conductivity reference value: $d_T$ is calculated from X according to an arithmetic expression. The arithmetic expression used here is preferably the following formula:

Arithmetic Expression 2:

$$d_T = (1\text{-}X)\times d_M + X\times d_L$$

(wherein $d_M$ and $d_L$ are constants experimentally determined in advance).

At S25, whether the elapsed time from start-up or last measurement of the electric conductivity of developer reaches a previously determined time is judged, and the operation advances to S24 when reached or advances to S28 when not reached.

At S24, the electric conductivity of developer is measured and the measured value is assigned to a variable: $d_M$. Then, at S25, this $d_M$ is compared with $d_T$, and the operation advances to S26 when $d_M$ is smaller or advances to S28 when $d_M$ is larger. At S26, the replenisher in a previously determined amount: $V_H$ is replenished to the developer and at next S27, X is updated by using $V_H$ and an arithmetic expression. At this time, the following arithmetic expression is preferably used.

Arithmetic Expression 3:

$$X = (V_T\times X_o+V_H) \div (V_T+V_H)$$

(wherein $X_o$ is a replenisher replacement ratio value before update, and $V_T$ is a volume of developer within developing tank).

At S28, the state of the operation switch for the automatic developer is checked, and the operation returns to S22 when the operation switch is turned on or the processing is terminated due to stopping of the apparatus when the operation switch is turned off.

In this way, the electric conductivity target value is sequentially calculated every time the development replenisher is replenished, by using a replenisher replacement ratio which is a ratio of the development replenisher replenished to developer, to the developer in the developing tank, so that despite a simple and inexpensive construction of the developing unit of the automatic developing machine, the fluctuation of developer sensitivity due to change in the processing conditions of development with a developer containing an electrolyte can be minimized.

The third control processing is described below by referring to Figs. 5 and 6. Here, the pairs A1 and A1, A2 and A2, and A3 and A3 in Figs. 5 and 6 each is linearly continuing between these Figures.

At S31, the aging replenishment integrated value: $I_C$ which is a variable used during control, is initialized, that is, 0 is assigned. Also, whether this automatic developing apparatus is first started or not is judged and when first started, the replenisher replacement ratio: X and aging replenishment ratio: F which are variables used during control, are initialized, that is, 0 is assigned to X and a previously determined constant: CF is assigned to F.

At S32, the aging replenishment amount corresponding to the stopped time: $T_F$ of the automatic developing apparatus is integrated to $I_c$, for example, by using the following arithmetic expression:

Arithmetic Expression 4:

$$I_C + V_F\times T_F\rightarrow I_C$$

(wherein $V_F$ is a constant experimentally determined in advance).

At S33, whether the elapsed time from start-up or last integration of the aging replenishment amount reaches a previously determined time: $T_K$ is judged, and the operation advances to S34 when reached or advances to S35 when not reached.

At S34, the aging replenishment amount necessary in the elapsed time: $T_K$ is integrated to $I_c$, for example, by using the following arithmetic expression:

Arithmetic Expression 5:

$$I_C + V_N\times T_K \rightarrow I_C$$

(wherein $V_N$ is a constant experimentally determined in advance).

At S35, the electric conductivity reference value: $d_T$ is calculated from X and F values by using an arithmetic

expression. The arithmetic expression used here is preferably the following formula:

$$d_T = (1-X)\times D_M + X\times((1-F)\times D_B + F\times D_C)$$

(wherein $D_M$, $D_B$ and $D_c$ are constants experimentally determined in advance).

At S36, whether the elapsed time from start-up or last measurement of the electric conductivity of developer reaches a previously determined time: $T_D$ is judged, and the operation advances to S37 when reached or advances to S42 when not reached.

At S37, the electric conductivity of developer is measured and the measured value is assigned to a variable: $d_M$. Then, at S38, the electric conductivity of developer: $d_M$ is compared with the electric conductivity reference value: $d_T$, and the operation advances to S39 when $d_M$ is smaller, otherwise advances to S42.

At S39, the replenisher in a previously determined amount $V_H$ is replenished to the developer.

At next S40, X and F values are updated by using $I_c$ and $V_H$ values. The updating of these values is suitably performed, for example, according to the following arithmetic expressions.

Arithmetic Expression 6:

$$(V_T\times X+V_H) \div (V_T+V_H) \rightarrow X$$

Arithmetic Expression 7:

$$(V_T\times X\times F+I_C) \div (V_T\times X+V_H)\rightarrow F$$

(wherein $V_T$ is a volume of developer within developing tank).

At next S41, $I_C$ is initialized, that is, 0 is assigned.

At S42, the state of the operation switch for the automatic developer is checked, and the operation returns to S33 when the operation switch is turned on or the processing is terminated due to stopping of the apparatus when the operation switch is turned off.

In this way, the electric conductivity target value is sequentially calculated every time either the development replenisher or diluent is replenished, by using a replenisher replacement ratio and an aging replenishment ratio which is a ratio of the development replenisher replenished based on the operation time and/or stopping time of the automatic developing machine to the entire replenishment amount of development replenisher to the developer in the developing tank, so that the optimal electric conductivity value can cope with fluctuation due to change in the processing conditions of development (ratio between processing replenishment amount and aging replenishment amount) or environmental conditions (humidity), and automatic processing of development with high sensitivity stability can be realized.

According to the control of the automatic developing machine described above, the ratio of aging replenishment amount · processing replenishment amount is automatically adjusted and therefore, the target electric conductivity value of an appropriate developer can be always established even when the size·processing frequency of photosensitive material is changed, so that a stable processing of development with constant sensitivity can be performed. As a result, despite a simple and inexpensive construction of the developing unit of the automatic developing machine, the fluctuation of developer sensitivity due to change in the processing conditions of development can be minimized.

A second embodiment of the present invention is described below. Fig. 7 is a constitutional view of the automatic developing apparatus according to the second embodiment of the present invention. As shown in Fig. 7, in the automatic developing apparatus 100 of this embodiment, processing units in the inside thereof are covered with an outer panel 114. Inside the outer panel 114, a developing unit 122 comprising a developing tank 118 for developing a PS plate 112 and an overflow pipe 120 for recovering the developer overflowed from the developing tank 118, a washing unit 124 for water-washing the developer adhered to the PS plate 112, and a finisher unit 126 for desensitizing the washed PS plate 112 by coating a gum solution are disposed. In the washing unit 124, a washing tank 128 is disposed and in the finisher unit 126, a gum solution tank 130 is disposed.

In the outer panel 114, a slit-shaped insert port 202 and a slit-shaped discharge port 204 are provided. In the top surface of the outer panel 114, a reentry insert port (sub-insert port) 250 for the insertion of the PS plate 112 between the developing unit 122 and the washing unit 124 is provided. This sub-insert port 250 works as a port for inserting the PS plate 112 in performing processing except for development.

At the sub-insert port 250, a blade 252 is disposed. The leading end of the blade 252 is in contact with the outer panel 114 acting as a guiding support surface for the sub-insert port 250, and the basal part thereof is fixed to the back surface side of the outer panel 114 through a bracket 254. Therefore, the sub-insert port 250 is in the state

of being closed by the blade 252.

The drying unit (not shown) dries the PS plate 112 by blowing warm air onto both surfaces thereof as the PS plate 112 delivered from the finisher unit 126 is transported by multiple rollers (not shown).

A pair of transport rollers 132 are disposed on the side of inserting the PS plate 112 into the developing tank 118 of the developing unit 122, and the PS plate 112 is inserted between this pair of transport rollers 132 from the insert port 202.

A rubber-made blade 206 is fixed in the vicinity of the transport roller 132 on the downstream side. The leading end of the blade 206 is in contact with the side wall of the developing tank 118 in the developing unit 122, and its basal part is attached to the outer panel 114 through a bracket 256. The bracket 256 comprises a fixed part 256A and a sliding part 256B attached to the fixed part 256A with a winged screw 258, and the blade 206 is fixed to the sliding part 256B. Therefore, in this construction, the leading end of the blade 206 can be separated from the side wall of the developing tank 118 by loosening the winged screw 258 and moving the sliding part 256B relative to the fixed part 256A.

Furthermore, in the vicinity of the insert port 102, a plate detection sensor 208 capable of determining the presence or absence of the PS plate 112 and measuring the plate area or the like of the plate transported is attached.

The developing tank 118 has a substantially inverted mountain shape with the top being opened and the bottom center part protruding downward. In this developing tank 118, a pump 260 is provided, and the developer in the developing tank 118 is sucked out by this pump 260 and jetted out from spray pipes 144 and 272 which are described later, whereby the developer stored in the developing tank 118 is circulated. During the circulation, the developer passes through an electric conductivity sensor 262 for measuring the electric conductivity of developer. Also, in the developing tank 118, the replenisher stock solution is supplied from a development replenisher stock solution tank 266 through a replenisher stock solution supply pump 264. Furthermore, as described later, in the developing tank 118, diluting water is supplied from the washing tank 128 through a pump 286.

The pumps 264 and 286 are controlled by a control device 50 comprising a controlling ROM 5a or controlling RAM 51b as a condition memorizing device and a time measuring unit 52, based on signals from the electric conductivity sensor 262 and the time measuring unit 52. The operational effects of the control device 50 are the same as those in the first embodiment and are not described here.

In the developing tank 118, a guide plate 268 is disposed on the upstream side, and many guide rollers 134 and a rotary brush roller 270 are disposed on the downstream side. These guide rollers 134 and rotary brush roller 270 are rotatably bridged over a pair of side boards of the developing tank 118.

A guide roller 136 having a relatively large diameter is disposed above the guide plate 268, and rotary brush rollers 138 and 270 and a guide roller 140 are disposed above the guide roller 134. Also, in the center part of the developing tank 118, a pair of squeeze rollers 142 having a function of squeezing the surface of the PS plate 112 are disposed.

The overflow pipe 120 is disposed on the most downstream side of the developing tank 118 and when the liquid surface of the developer exceeds a predetermined level, the developer is guided by this pipe to a waste solution tank 284.

A liquid surface cover 150 is disposed on the surface of developer in the developing tank 118. The liquid surface cover 150 is protruding nearly like an arc at the portion corresponding to the rotary brush roller 138 and guide roller 140 adjacent thereto, and contacting with the liquid surface of developer so as to maximally prevent the developer from contacting with air. Also, the liquid surface cover 150 is slidably held at its both edges in the transport direction of the PS plate 112 by the side boards (not shown) in such a manner as to permit a vertical motion of the cover in accordance with increase or decrease of the developer.

The end of the liquid surface cover 150 on the downstream side in the transport direction is in contact with the leading end of a blade 274.

The blade 274 is fixed to the outer panel 114 via a bracket 276. The liquid surface of the developer exposed at the downstream end of the liquid cover 150 in the transport direction is separated by this blade 274 from the upper portion of the liquid surface cover 150, and the upper space of the liquid surface cover 150 is perfectly isolated from external air by the blade 206 (in the state of contacting with the side wall of the developing tank 118) in the vicinity of the insert port 202, whereby the developer can be prevented from evaporation.

On the most downstream side of the developing tank 118 in the transport direction, a pair of rollers 154 for holding and transporting the PS plate 112 and at the same time, squeezing the developer from the surface of the PS plate 112 are disposed.

On the other hand, in the automatic developing apparatus 100, the washing tank 128 of the washing unit 124 is disposed on the downstream side of the developing unit 122, and two pairs of transport rollers 152 and 153 are disposed above the washing tank 128.

The washing tank 128 stores washing water used for washing out the developer on the PS plate 112 delivered from the developing tank 118. A spray pipe 156 is disposed on the upstream side of the transport roller 153 and above the transport passage. In the outer circumference of the spray pipe 156, a plurality of ejection ports communicating

with the inside are provided. The washing water pumped up by the pump 280 from the washing water tank 278 is dropped from the spray pipe 156 on the upper roller of the transport rollers 153 and with the rotation of the transport roller 153, the washing water readily spreads on the surface of the PS plate 112, whereby the surface of the PS plate 112 is cleaned with the washing water.

The lower roller of the transport roller 152 or 153 is housed at its bottom in a pan 162. The pan 162 stores washing water, and the washing water is scooped up by the lower roller and used to clean the back surface of the PS plate 112 and also prevent the drying of the upper transport roller 152 or 153.

The washing water spread laterally on the front surface of the PS plate 112 falls into the pan 162 from both ends in the crosswise direction of the PS plate 112, and the washing water scooped up from the pan 162 is used to treat the back surface of the PS plate 112. The washing water overflowed from the pan 162 is guided into the washing tank 128. In the washing tank 128, an overflow pipe 282 is disposed and when the waste water exceeds a predetermined liquid surface, the washing water is discarded into the waste solution tank 284.

The washing tank 128 and the developing tank 118 are communicating with each other via a pump 286 and when the pump 286 is driven, the washing water in the washing tank 128 is guided into the developing tank 118 and can be used as a diluent at the time of supplying the replenisher stock solution to the developing tank 118.

A pair of transport rollers 178 are provided above the gum solution tank 130 of the finisher unit 126. The PS plate 112 delivered by the transport rollers 153 is guided to the transport rollers 178.

On the upstream side of the transport rollers 178, spray pipes 182 and 288 are disposed above the transport passage and below the transport passage, respectively. The gum solution pumped up by a pump 292 from the gum solution tank 290 is ejected from the spray pipe 182 or 288 and supplied to the front or back surface of the PS plate 112.

The transport rollers 178 hold and transport the PS plate 112 and at the same time, squeeze the gum solution supplied by the spray pipe 182 for desensitizing the surface of the PS plate 112. The gum solution squeezed off from the surface of the PS plate 112 is recovered in the gum solution tank 130. The gum solution in the gum solution tank 130 is circulated by the pump 294. In the gum solution tank 130, an overflow pipe 296 is provided and when the gum solution exceeds a predetermined liquid surface, the gum solution is guided to and discarded in the waste solution tank 284.

The bottom of the lower transport roller 178 is immersed in the gum solution stored in the gum solution tank 130, and the gum solution is scooped up by the lower transport roller 178 from the gum solution tank 130 and coated on the back surface of the PS plate 112, whereby the back surface of the PS plate 112 is desensitized with the gum solution scooped up by the transport roller 178 and at the same time, the upper transport roller 178 is prevented from drying to allow for no precipitation of the components of the processing solution on the surface of the transport roller 178.

The PS plate 112 after the completion of treatments in the finisher unit 126 is delivered to the drying unit (not shown) through the discharge port 204 of a casing 200.

A lid body 210 serving as a shutter is provided at the discharge port 204. The lid body 210 is fixed to a shaft 212. The shaft 212 can be rotated by a driving device (for example, a solenoid) (not shown). The shaft 212 rotates based on the detection of PS plate 112 by the plate detection sensor 208 provided in the vicinity of the insert port 202. More specifically, the lid body 210 is kept at a substantially horizontal position (opened state of discharge port 204) during the time of detecting the PS plate 112 by the plate detection sensor 208 and during the passage of a predetermined time after the plate is not detected (after the rear end is detected), or otherwise kept at a vertical position (closed state of discharge port 204).

The operation of this embodiment is described below. The processing tanks such as developing tank 118, washing tank 128 and gum solution tank 130 are covered with a casing 200 such as top cover 114 and main body 108. In the case where the development of PS plate 112 is not being processed in the automatic developing apparatus 100, the blade 206 is in contact with the side wall of the developing tank 118 and therefore, the insert port 202 is closed. Also, the plate detection sensor 208 does not detect the PS plate 112 and therefore, the lid body 210 is in the vertical position to close the discharge port 204. Furthermore, the sub-insert port 250 is also closed by the blade 252, and the space above the liquid surface cover 150 of the developing unit 122 is also closed by the blades 206 and 122. Therefore, the developer in the developing tank 118, the washing water in the washing unit 124 and the gum solution in the finisher unit 126 are protected from exposure to external air and substantially free of carbon dioxide fatigue. As a result, the developing capability can be prevented from reduction due to aging deterioration and therefore, the replenishment amount of, for example, the replenisher stock solution in the developing unit 122 can be drastically reduced. In particular, the developer surface of the developing tank 118 is covered with the liquid surface cover 150 and therefore, the effect of preventing the developer from contact with external air is large.

Incidentally, the lid body 210 is preferably made open as short as possible so as to minimize the contact of developer with external air. Accordingly, in a preferred constitution, the lid body is opened only when the PS plate 112 is passing, and closed at other times.

The control by the control device 50 is the same as the contents in the flow chart of Figs. 2, 3, 4, 5 and 6 described above for the first embodiment and showing the replenishment method of the development replenisher and

therefore, this is not described here.

Example 1

The present invention is described below by referring to Examples, but the present invention is not limited to these Examples. In Examples, "%" is all "weight%". Preparation of $SiO_2$-Containing Alkali Developer/Development replenisher

Developer (1) which was an aqueous 4.0% potassium silicate solution containing silicon oxide $SiO_2$ and potassium oxide $K_2O$ at a mixing ratio $SiO_2/K_2O$ of 1.1 was prepared. Also, alkali development replenishers (1) to (8) according to the present invention were prepared by adding various electric conductivity adjusting agents in an amount shown in Table 1 below to 1 L of an aqueous 6.0% potassium silicate solution containing silicon oxide $SiO_2$ and potassium oxide $K_2O$ at a mixing ratio $SiO_2/K_2O$ of 1.1. Furthermore, comparative development replenisher (1) having not added thereto an electric conductivity adjusting agents was prepared.

Preparation of Nonreducing Sugar-Containing Alkali Developer/Development replenisher

Developer (2) which was 1 L of an aqueous 5.0% D-sorbitol potassium salt solution comprising a combination of nonreducing sugar and base and containing D-sorbitol/potassium oxide $K_2O$ was prepared. Also, alkali development replenishers (9) to (16) according to the present invention were prepared by adding various electric conductivity adjusting agents in an amount shown in Table 1 below to 1 L of an aqueous 6.5% D-sorbitol potassium salt solution comprising a combination of nonreducing sugar and base and containing D-sorbitol/potassium oxide $K_2O$ were prepared. Furthermore, comparative development replenisher (2) having not added thereto an electric conductivity adjusting agents was prepared.

Table 1

| Developer/Development replenisher | | |
|---|---|---|
| No. | Electric Conductivity Adjusting Agent | Density |
| (1) (9) | tripotassium citrate | 7 g/L |
| (2) (10) | tripotassium citrate | 14 g/L |
| (3) (11) | trisodium citrate | 14 g/L |
| (4) (12) | potassium succinate | 14 g/L |
| (5) (13) | potassium salicylate | 14g/L |
| (6) (14) | potassium p-toluenesulfonate | 14 g/L |
| (7) (15) | potassium carbonate | 14 g/L |
| (8) (16) | sodium carbonate | 14g/L |
| Comparative Example (1)(2) | - | - |

By using a heat-sensitive positive lithographic printing plate, development processing with various alkali development processing solutions shown above was performed.

Production of Heat-Sensitive Positive Lithographic Printing Plate

A 0.3 mm-thick aluminum plate (construction material: 1050) was degreased by washing it with trichloroethylene. Thereafter, the surface thereof was grained by using a nylon brush and a 400-mesh pumice-water suspension and then thoroughly washed with water. After the washing, the aluminum plate was etched by dipping it in an aqueous 25% sodium hydroxide solution at 45°C for 9 seconds, then washed with water, dipped in an aqueous 20% nitric acid solution for 20 seconds, and again washed with water. At this time, the etched amount of the grain surface was about 3 g/$m^2$.

Subsequently, this aluminum plate was treated by using 7% sulfuric acid as an electrolytic solution and passing DC current at a current density of 15 A/$dm^2$ to provide an anodic oxide film of 3 g/$m^2$, then washed with water and dried. The resulting aluminum plate was treated with an aqueous 2.5% sodium silicate solution at 30°C for 10 seconds and thereafter, the following coating solution for undercoat layer was coated and dried at 80°C for 15 seconds, thereby obtaining a support. The dry coated amount of the undercoat layer after drying was 15 mg/$m^2$.

Coating Solution for Undercoat Layer

| | |
|---|---|
| Copolymer P shown below (molecular weight: 28,000) | 0.3 g |
| Methanol | 100 g |
| Water | 1 g |

Copolymer P:

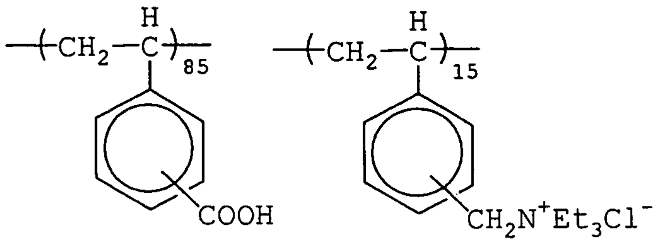

Synthesis Example 1 (Synthesis of Carboxyl Group-Containing Alkali-Soluble Polymer Compound (Copolymer)):

Into a 20 ml-volume three-neck flask equipped with a stirrer, a condenser tube and a dropping funnel, 6.39 g (0.045 mol) of n-propyl methacrylate, 1.29 g (0.015 mol) of methacrylic acid and 20 g of 1-methoxy-2-propanol were charged. Then, the resulting mixture was stirred under heating at 65°C on a hot water bath and after adding thereto 0.15 g of "V-601" (produced by Wako Pure Chemical Industries, Ltd.), the mixture was stirred in a nitrogen stream for 2 hours while keeping the temperature at 70°C. To this reaction mixture, a mixture containing 6.39 g (0.045 mol) of n-propyl methacrylate, 1.29 g (0.015 mol) of methacrylic acid, 20 g of 1-methoxy-2-propanol and 0.15 g of "V-601" was added dropwise through the dropping funnel over 2 hours. After the completion of dropwise addition, the resulting mixture was further stirred at 90°C for 2 hours. After the reaction was terminated, 40 g of methanol was added thereto, and the resulting mixture was cooled, then poured into 2 liter of water while stirring the water, and stirred for 30 minutes. Thereafter, the precipitate was collected by filtration and dried to obtain 15 g of a white solid. The weight average molecular weight (polystyrene standard) of the obtained copolymer was measured by gel permeation chromatography and found to be 53,000.

Synthesis Example 2 (Synthesis of Carboxyl Group-Containing Alkali-Soluble Polymer Compound (Copolymer)):

A copolymer was synthesized by the same operation as in Synthesis Example 1 except for using ethyl methacrylate/isobutyl methacrylate/methacrylic acid (mol%: 35/35/30). The weight average molecular weight (polystyrene standard) of the copolymer was measured and found to be 50,000.

Synthesis Example 3 (Synthesis of Carboxyl Group-Containing Polyurethane Resin):

In a 500 ml-volume three-neck round-bottom flask equipped with a condenser tube and a stirrer, 14.6 g (0.109 mol) of 2,2-bis(hydroxymethyl)propionic acid, 13.3 g (0.0686 mol) of tetraethylene glycol and 2.05 g (0.0228 mol) of 1,4-butanediol were charged and dissolved in 118 g of N,N-dimethylacetamide. To this mixture, 30.8 g (0.123 mol) of 4,4'-diphenylmethane diisocyanate, 13.8 g (0.0819 mol) of hexamethylene diisocyanate and 0.1 g of di-n-butyltin dilaurate as a catalyst were added. The resulting mixture was heated at 90°C for 7 hours with stirring. Subsequently, 100 ml of N,N-dimethylacetamide, 50 ml of methanol and 50 ml of acetic acid were added to the reaction mixture and after stirring it, the mixture was poured into 4 liter of water with stirring to precipitate a white polymer. The polymer was separated by filtration, washed with water and then dried under reduced pressure to obtain 60 g of a polymer.
The molecular weight of the polymer was measured by gel permeation chromatography (GPC) and found to be 70,000 in terms of the weight average molecular weight (polystyrene standard). Also, the carboxyl group content was measured by titration and found to be 1.43 meq/g.

Synthesis Example 4 (Synthesis of Carboxyl Group-Containing Polyurethane Resin):

A copolymer was synthesized in the same manner as in Synthesis Example 3 except for using the following diisocyanate compound (mol%):

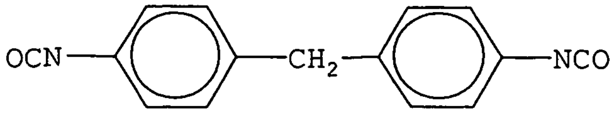

(70)

$OCN(CH_2)_6NCO$

(30)

and the following diol compound (mol%):

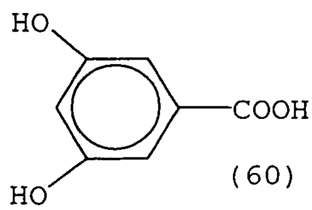

(60)

$HO(CH_2)_6OH$

(40)

The acid content of the obtained copolymer was determined by titration and found to be 1.72 meq/g, and the weight average molecular weight (polystyrene standard) was 80,000.

Synthesis Example 5:

Into a 500 ml-volume three-neck flask equipped with a stirrer, a condenser tube and a dropping funnel, 31.0 g (0.36 mol) of methacrylic acid, 39.1 g (0.36 mol) of ethyl chloroformate and 200 ml of acetonitrile were charged. Then, the resulting mixture was stirred under cooling on an ice water bath. To this mixture, 36.4 g (0.36 mol) of triethylamine was added dropwise through the dropping funnel over about 1 hour. After the completion of dropwise addition, the ice water bath was removed, and the mixture was stirred at room temperature for 30 minutes. To the obtained reaction mixture, 51.7 g (0.30 mol) of p-aminobenzenesulfonamide was added, and the resulting mixture was stirred for 1 hour while warming it to 70°C on an oil bath. After the reaction was terminated, the reaction mixture was poured into 1 liter of water while stirring the water, and the resulting mixture was stirred for 30 minutes. This mixture was filtered to collect the precipitate and after forming the precipitate into a slurry with 500 ml of water, the slurry was filtered and the obtained solid was dried, whereby a white solid of N-(p-aminosulfonylphenyl)methacrylamide (yield: 46.9 g) was obtained. Subsequently, 4.61 g (0.0192 mol) of N-(p-aminosulfonylphenyl)methacrylamide, 2.94 g (0.0258 mol) of ethyl methacrylate, 0.80 g (0.015 mol) of acrylonitrile and 20 g of N,N-dimethylacetamide were charged into a 20 ml-volume three-neck flask equipped with a stirrer, a condenser tube and a dropping funnel, and the resulting mixture was stirred under heating to 65°C on a hot water bath. To this mixture, 0.15 g of "V-65" (produced by Wako Pure Chemical Industries, Ltd.) was added, and the resulting mixture was stirred in a nitrogen stream while keeping the temperature at 65°C for 2 hours. To this reaction mixture, a mixture containing 4.61 g of N-(p-aminosulfonylphenyl)methacrylamide, 2.94 g of ethyl methacrylate, 0.80 g of acrylonitrile, N,N-dimethylacetamide and 0.15 g of "V-65" was added dropwise through the dropping funnel. After the completion of dropwise addition, the resulting mixture was further stirred at 65°C for 2 hours. After the reaction was terminated, 40 g of methanol was added to the mixture, and the resulting mixture was cooled, then poured into 2 liter of water while stirring the water, and stirred for 30 minutes. Thereafter, the precipitate was collected by filtration and dried to obtain 15 g of a white solid. The weight average molecular weight (polystyrene standard) of the obtained specific copolymer was measured by gel permeation chromatography and found to be 53,000.

On the obtained support, a coating solution for image recording layer shown below was coated and dried at 150°C for 30 seconds to have a dry coated amount of 1.8 g/$m^2$, whereby Positive Lithographic Printing Plate Precursor A was obtained.

| Coating Solution for Image Recording Layer | |
|---|---|
| Copolymer of Synthesis Example 2 | 0.050 g |
| Copolymer of Synthesis Example 4 | 0.050 g |
| Copolymer of Synthesis Example 5 | 0.4 g |
| m,p-Cresol novolak (m/p ratio = 6/4, weight average molecular weight: 8,000, containing 0.5% ofunreacted cresol) | 0.6 g |
| Cyanine Dye A | 0.1 g |
| Phthalic anhydride | 0.05 g |
| p-Toluenesulfonic acid | 0.002 g |
| Ethyl Violet (counter ion: 6-hydroxy-β-naphthalenesulfonic acid) | 0.02 g |
| Esterified product of naphthoquinone 1,2-diazide-5-sulfonyl chloride and pyrogallol-acetone resin | 0.01 g |
| Fluorine-containing surfactant (Megafac F-177, produced Dai-Nippon Ink & Chemicals, Inc.) | 0.05 g |
| Methyl ethyl ketone | 8 g |
| 1-Methoxy-2-propanol | 4 g |

On an aluminum support treated in the same manner as above to provide an undercoat layer, Coating Solution 1 for Image Recording Layer was coated by a wire bar to have a coated weight of 0.85 g/m$^2$ and then dried at 140°C for 50 seconds by using PERFECT OVEN PH200 manufactured by TABAI and setting the Wind Control to 7. Furthermore, Coating Solution 2 for Image Recording Layer was coated thereon by a wire bar to have a coated amount of 0.22 g/m$^2$ and then dried at 120°C for 60 seconds by using PERFECT OVEN PH200 manufactured by TABAI and setting the Wind Control to 7 to obtain Lithographic Printing Plate Precursor B with an image-forming layer having a two-layer constitution.

| Coating Solution 1 for Image Recording Layer | |
|---|---|
| Copolymer of Synthesis Example 2 | 0.050 g |
| Copolymer of Synthesis Example 4 | 0.050 g |
| N-(4-Aminosulfonylphenyl)methacrylamide/acrylonitrile/methyl methacrylate (36/34/30, weight average molecular weight: 50,000) | 1.896 g |
| Cresol novolak (m/p=6/4, weight average molecular weight: 4,500, residual monomer: 0.8 wt%) | 0.237 g |
| Cyanine Dye A | 0.109 g |
| 4,4'-Bishydroxyphenylsulfone | 0.063 g |
| Tetrahydrophthalic anhydride | 0.190 g |
| p-Toluenesulfonic acid | 0.008 g |
| Ethyl Violet with the counter ion being changed to 6-hydroxynaphthalenesulfone) | 0.05 g |
| Fluorine-containing surfactant (F176, produced Dai-Nippon Ink & Chemicals, Inc.) | 0.035 g |
| Methyl ethyl ketone | 26.6 g |
| 1-Methoxy-2-propanol | 13.6 g |
| γ-Butyrolactone | 13.8 g |

| Coating Solution 2 for Image Recording Layer | |
|---|---|
| Copolymer of Synthesis Example 2 | 0.050 g |
| Copolymer of Synthesis Example 4 | 0.050 g |
| Cresol novolak (m/p=6/4, weight average molecular weight: 4,500, residual monomer: 0.8 wt%) | 0.237 g |
| Cyanine Dye A | 0.047 g |
| Dodecyl stearate | 0.060 g |
| 3-Methoxy-4-diazodiphenylamine hexafluorophosphate | 0.030 g |
| Fluorine-containing surfactant (F176 (20% solution), produced Dai-Nippon Ink & Chemicals, Inc.) | 0.110 g |
| Fluorine-containing surfactant (MCF312F (30% solution), produced Dai-Nippon Ink & Chemicals, Inc.) | 0.12 g |
| Methyl ethyl ketone | 15.1 g |
| 1-Methoxy-2-propanol | 7.7 g |

Lithographic Printing Plate Precursors A and B obtained above each was exposed at a main scanning speed of 5 m/sec by using a semiconductor laser having an output of 500 mW, a wavelength of 830 nm and a beam diameter of 17 μm ($1/e^2$), and then kept at 25°C. The fluctuation width of developer sensitivity was experimentally determined on respective cases where these exposed lithographic printing plates were processed by using the replenishment method for development replenisher according to the embodiment described above or by using a related art replenishment method for development replenisher.

Processing of Examples 1 to 18

As shown in Tables 2 and 3, a continuous processing was performed by using the replenishment method of the present invention, and the developer sensitivity stability was evaluated. In the evaluation of developer sensitivity stability, the photosensitive material was exposed by a halftone mode (AM screening, screen ruling = 175 lpi) and to what extent the image density of the obtained image having a gradation density of 50% was changed after development was examined. The results are shown in Table 4.

Processing of Comparative Examples 1 to 8

As shown in Tables 2 and 3, a continuous processing was performed by using the area aging-based replenishment method, and the developer sensitivity stability was evaluated. In the evaluation of developer sensitivity stability, the photosensitive material was exposed by a halftone mode (AM screening, screen ruling = 175 lpi) and to what extent the image density of the obtained image having a gradation density of 50% was changed after development was examined. The results are shown in Table 4.

Table 2

| | Replenishment system | Lithographic Printing Plate Precursor | Developer | Replenisher | Processing Condition |
|---|---|---|---|---|---|
| Example 1 | system of the Invention (control system shown in Figs. 5 and 6) | A, B | (1) | (1) | 1 |
| Example 2 | ditto | A, B | (1) | (1) | 2 |
| Example 3 | ditto | A, B | (1) | (2) | 1 |
| Example 4 | ditto | A, B | (1) | (3) | 1 |
| Example 5 | ditto | A, B | (1) | (4) | 1 |
| Example 6 | ditto | A, B | (1) | (5) | 1 |
| Example 7 | ditto | A, B | (1) | (6) | 1 |
| Example 8 | ditto | A, B | (1) | (7) | 1 |
| Example 9 | ditto | A, B | (1) | (8) | 1 |
| Example 10 | ditto | A, B | (2) | (9) | 1 |
| Example 11 | ditto | A, B | (2) | (9) | 2 |
| Example 12 | ditto | A, B | (2) | (10) | 1 |
| Example 13 | ditto | A, B | (2) | (11) | 1 |
| Example 14 | ditto | A, B | (2) | (12) | 1 |
| Example 15 | ditto | A, B | (2) | (13) | 1 |
| Example 16 | ditto | A, B | (2) | (14) | 1 |
| Example 17 | ditto | A, B | (2) | (15) | 1 |
| Example 18 | ditto | A, B | (2) | (16) | 1 |
| Comparative Example 1 | ditto | A, B | (1) | Comparative (1) | 1 |
| Comparative Example 2 | ditto | A, B | (2) | Comparative (2) | 1 |
| Comparative Example 3 | area aging-based replenishment system (no detection of electric conductivity) | A, B | (1) | (1) | 3 |
| Comparative Example 4 | ditto | A, B | (2) | (2) | 3 |
| Comparative Example 5 | ditto | A, B | (1) | (1) | 4 |
| Comparative Example 6 | ditto | A, B | (2) | (2) | 4 |
| Comparative Example 7 | ditto | A, B | (1) | Comparative (1) | 3 |
| Comparative Example 8 | ditto | A, B | (2) | Comparative (2) | 3 |

Table 3

| | Automatic Developing Machine | Volume of Developing Tank | Development Temperature | Development Time | Aging Replenishment amount in Operation | Aging Replenishment amount at Stopping | Processing Replenishment amount |
|---|---|---|---|---|---|---|---|
| Processing condition 1 | Fig. 7 | 20000 ml | 30°C | 12 sec. | - | - | - |
| Processing condition 2 | Fig. 1 | 20000 ml | 30°C | 12 sec. | - | - | - |
| Processing condition 3 | Fig. 7 | 20000 ml | 30°C | 12 sec. | 220 ml/h | 100 ml/h | 40 ml/$m^3$ |
| Processing condition 4 | Fig. 1 | 20000 ml | 30°C | 12 sec. | 50 ml/h | 15 ml/h | 20 ml/$m^3$ |

Throughput: common between Lithographic Printing Plate Precursors A and B.

Throughput per day: 13 plates with the area of one plate being 0.8 $m^2$.

Table 4

| | Change in 50% Gradation Density (assuming that the density at the start on the 1st day is ±0.0%) | | | | | | | | | |
|---|---|---|---|---|---|---|---|---|---|---|
| Day | 1st | 2nd | 3rd | 4th | 5th | 8th | 9th | 10th | 11th | 12th |
| Example 1 | ±0.0% | +0.20% | +0.25% | -1.25% | -1.25% | -1.25% | -1.25% | +1.0% | +1.50% | +1.50% |
| Example 2 | ±0.0% | -0.25% | ±0.0% | -1.25% | -1.5% | -1.5% | -1.25% | +1.25% | +1.25% | +1.75% |
| Example 3 | ±0.0% | +0.25% | +0.25% | -1.25% | -1.25% | -1.25% | -1.25% | -0.15% | +1.0% | +1.5% |
| Example 4 | ±0.0% | +0.25% | +0.25% | -1.25% | -1.25% | +1.0% | -1.25% | -0.50% | +1.25% | +1.5% |
| Example 5 | ±0.0% | +0.25% | +0.25% | -1.25% | -1.25% | -1.25% | +1.25% | -0.15% | +1.0% | +1.5% |
| Example 6 | ±0.0% | +0.25% | +0.25% | -1.25% | -1.25% | -1.25% | -1.25% | +0.50% | +1.0% | +1.5% |
| Example 7 | ±0.0% | +0.25% | +0.25% | -1.25% | -1.25% | -1.25% | -1.25% | -0.15% | +1.25% | +1.5% |
| Example 8 | ±0.0% | -0.25% | ±0.0% | -1.25% | -1.5% | -1.5% | -1.25% | +0.25% | +1.25% | +1.75% |
| Example 9 | ±0.0% | +0.25% | +0.25% | -1.25% | -1.25% | -1.25% | -1.25% | +0.25% | +1.0% | +1.5% |
| Example 10 | ±0.0% | +0.25% | +0.25% | -0.5% | -1.25% | -1.25% | -1.25% | -0.15% | +1.0% | +1.5% |
| Example 11 | ±0.0% | +0.25% | +0.25% | -1.25% | -1.25% | +1.0% | -1.25% | -0.50% | +1.0% | +1.75% |
| Example 12 | ±0.0% | +0.25% | +0.25% | -1.25% | -1.25% | -1.25% | -1.25% | -0.15% | +1.0% | +1.5% |
| Example 13 | ±0.0% | +0.25% | +0.25% | -1.25% | -1.25% | -1.25% | -1.25% | -0.15% | +1.25% | +1.5% |
| Example 14 | ±0.0% | -0.25% | ±0.0% | -1.25% | -1.5% | -1.5% | -1.25% | +0.25% | +1.25% | +1.75% |
| Example 15 | ±0.0% | +0.25% | +0.25% | -1.25% | -1.25% | -1.25% | -1.25% | +0.25% | +1.0% | +1.5% |
| Example 16 | ±0.0% | +0.25% | +0.25% | -0.5% | -1.25% | -1.25% | -1.25% | -0.15% | +1.0% | +1.5% |
| Example 17 | ±0.0% | +0.25% | +0.25% | -1.25% | -1.25% | +1.0% | -1.25% | -0.50% | +1.0% | +1.75% |
| Example 18 | ±0.0% | +0.25% | +0.25% | -1.25% | -1.25% | -1.25% | -1.25% | -0.15% | +1.0% | +1.5% |
| Comparative Example 1 | ±0.0% | ±0.0% | +0.25% | +0.25% | +0.25% | -0.5% | -1.25% | -1.50% | +1.75% | +2.5% |
| Comparative Example 2 | ±0.0% | ±0.0% | +0.25% | +0.25% | +0.25% | -0.5% | -1.25% | -0.5% | +1.5% | +2.5% |
| Comparative Example 3 | ±0.0% | ±0.0% | ±0.0% | +0.25% | +0.25% | +0.75% | +1.5% | +2.0% | +2.75% | +3.25% |
| Comparative Example 4 | ±0.0% | -0.25% | +0.25% | +0.25% | ±0.0% | +1.25% | +1.5% | +2.5% | +3.25% | +3.5% |
| Comparative Example 5 | ±0.0% | ±0.0% | ±0.0% | +0.25% | +0.25% | +0.75% | +1.5% | +2.25% | +2.5% | +3.25% |
| Comparative Example 6 | ±0.0% | -0.25% | +0.25% | +0.25% | ±0.0% | +1.25% | +1.5% | +2.5% | +3.5% | +3.75% |
| Comparative Example 7 | ±0.0% | ±0.0% | ±0.0% | +0.25% | +0.25% | +0.75% | +1.5% | +2.5% | +3.5% | +4.25% |
| Comparative Example 8 | ±0.0% | -0.25% | +0.25% | +0.25% | ±0.0% | +1.25% | +1.5% | +2.75% | +3.75% | +4.5% |

From these evaluations, it could be confirmed that in Comparative Examples 1 to 8, the change of 50% gradation density is out of the range from -2.0% to +2.0%, whereas in Examples 1 to 18 using the system of the present invention, the change of 50% gradation density falls within the range from -2.0% to +2.0%.

According to the present invention, at the time of developing a large number of exposed photosensitive lithographic printing plates with a developer containing an electrolyte, the electric conductivity of the developer is measured and when the measured electric conductivity value of the developer is lower than the previously determined reference value for the electric conductivity, a development replenisher containing an electric conductivity adjusting agent of elevating the liquid electric conductivity is replenished, whereby despite the simple and inexpensive device construction, the fluctuation of developer activity due to change in the processing conditions (size or kind of photosensitive lithographic printing plate) can be prevented and an automatic development processing with high sensitivity stability can be realized.

The entire disclosure of each and every foreign patent application from which the benefit of foreign priority has been claimed in the present application is incorporated herein by reference, as if fully set forth.

## Claims

**1.** A method for replenishing a development replenisher in an automatic developing machine, wherein the automatic developing machine develops a plurality of photosensitive lithographic printing plates that were exposed with a developer containing an electrolyte, the method comprising:

measuring an electric conductivity of the developer;
comparing the electric conductivity of the developer with a reference electric conductivity; and
replenishing a development replenisher containing an electric conductivity adjusting agent to the developer, when the electric conductivity of the developer is lower than the reference electric conductivity, so that the electric conductivity of the developer increases to keep an activity of the developer substantially constant.

**2.** The method according to claim 1,
wherein an electric conductivity calculated from a total amount of the plurality of photosensitive lithographic printing plates processed with the developer is used as the reference electric conductivity.

**3.** The method according to claim 1,
wherein an electric conductivity calculated from a replenisher replacement ratio is used as the reference electric conductivity,
wherein the replenisher replacement ratio is an amount ratio of the development replenisher, which is replenished to the developer, based on the developer.

**4.** The method according to claim 1,
wherein an electric conductivity calculated from a replenisher replacement ratio and an aging replenishment ratio is used as the reference electric conductivity,
wherein the replenisher replacement ratio is an amount ratio of the development replenisher, which is replenished to the developer, based on the developer, and the aging replenishment ratio is a ratio of an aging replenishment amount, which is calculated from an operated time and a stopped time of the automatic developing machine, based on a total replenishment amount.

FIG. 1

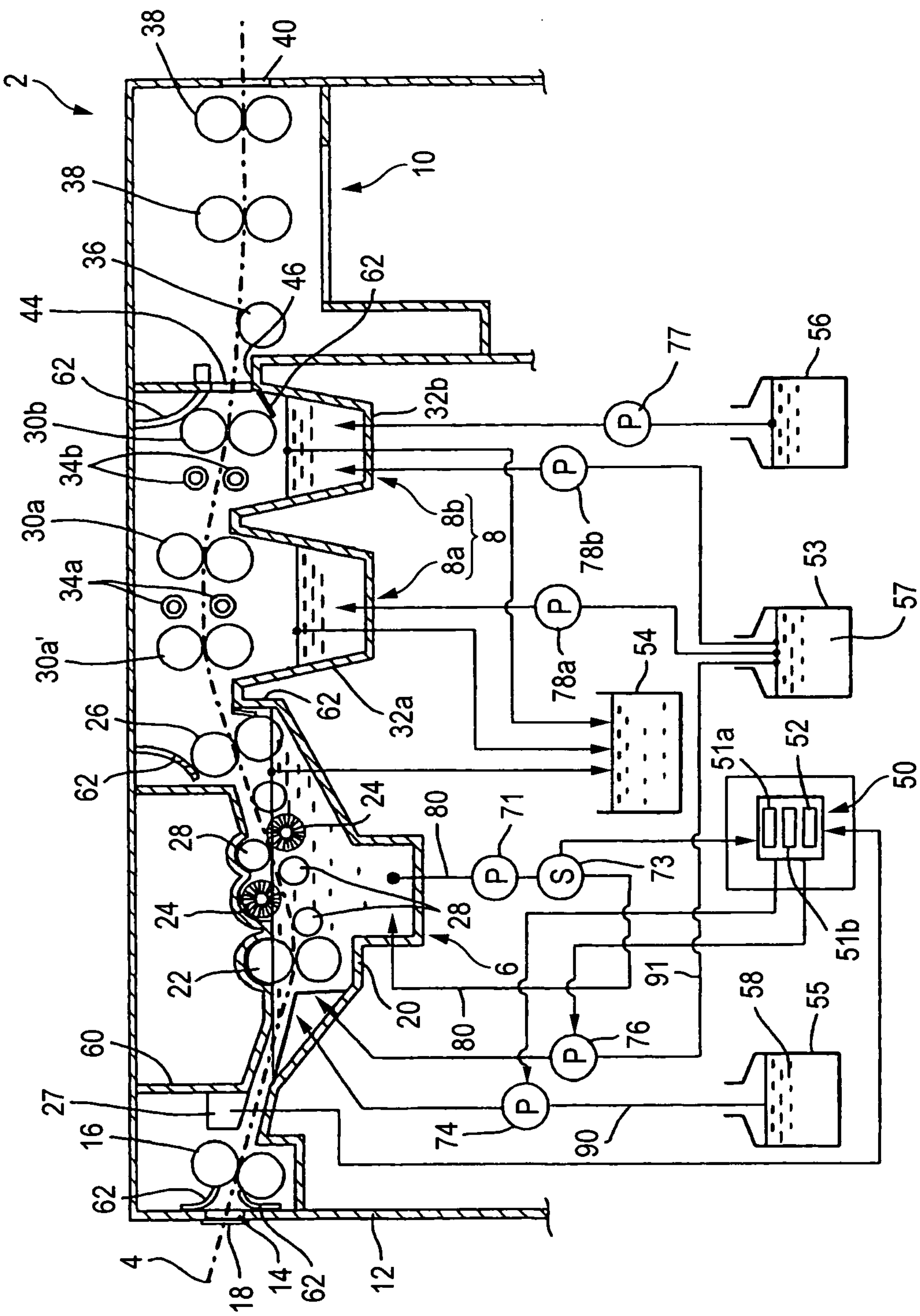
2
4
6
8
8a
8b
10
12
14
16
18
20
22
24
26
27
28
30a
30a'
30b
32a
32b
34a
34b
36
38
40
44
46
50
51a
51b
52
53
54
55
56
57
58
60
62
71
73
74
76
77
78a
78b
80
90
91
P
S

FIG. 2

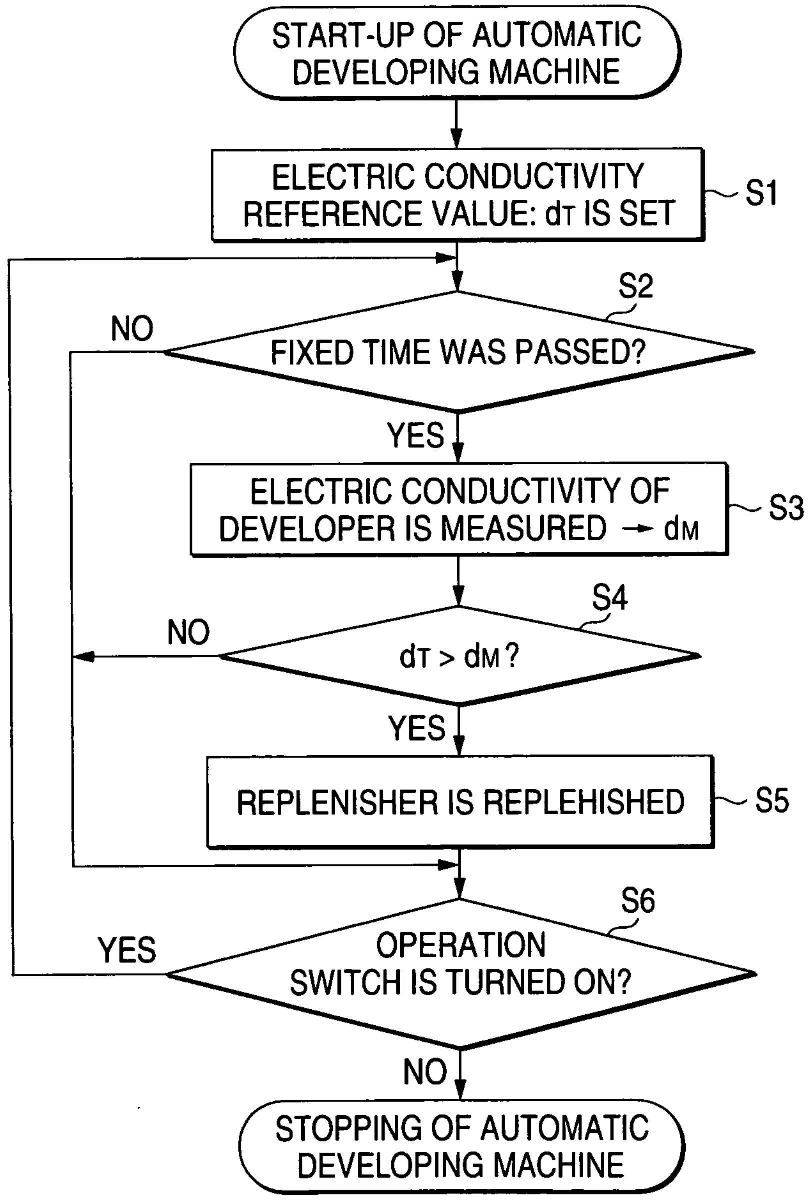

START-UP OF AUTOMATIC DEVELOPING MACHINE
ELECTRIC CONDUCTIVITY REFERENCE VALUE: dT IS SET
S1
S2
FIXED TIME WAS PASSED?
NO
YES
ELECTRIC CONDUCTIVITY OF DEVELOPER IS MEASURED → dM
S3
S4
dT > dM ?
NO
YES
REPLENISHER IS REPLEHISHED
S5
S6
OPERATION SWITCH IS TURNED ON?
YES
NO
STOPPING OF AUTOMATIC DEVELOPING MACHINE

FIG. 3

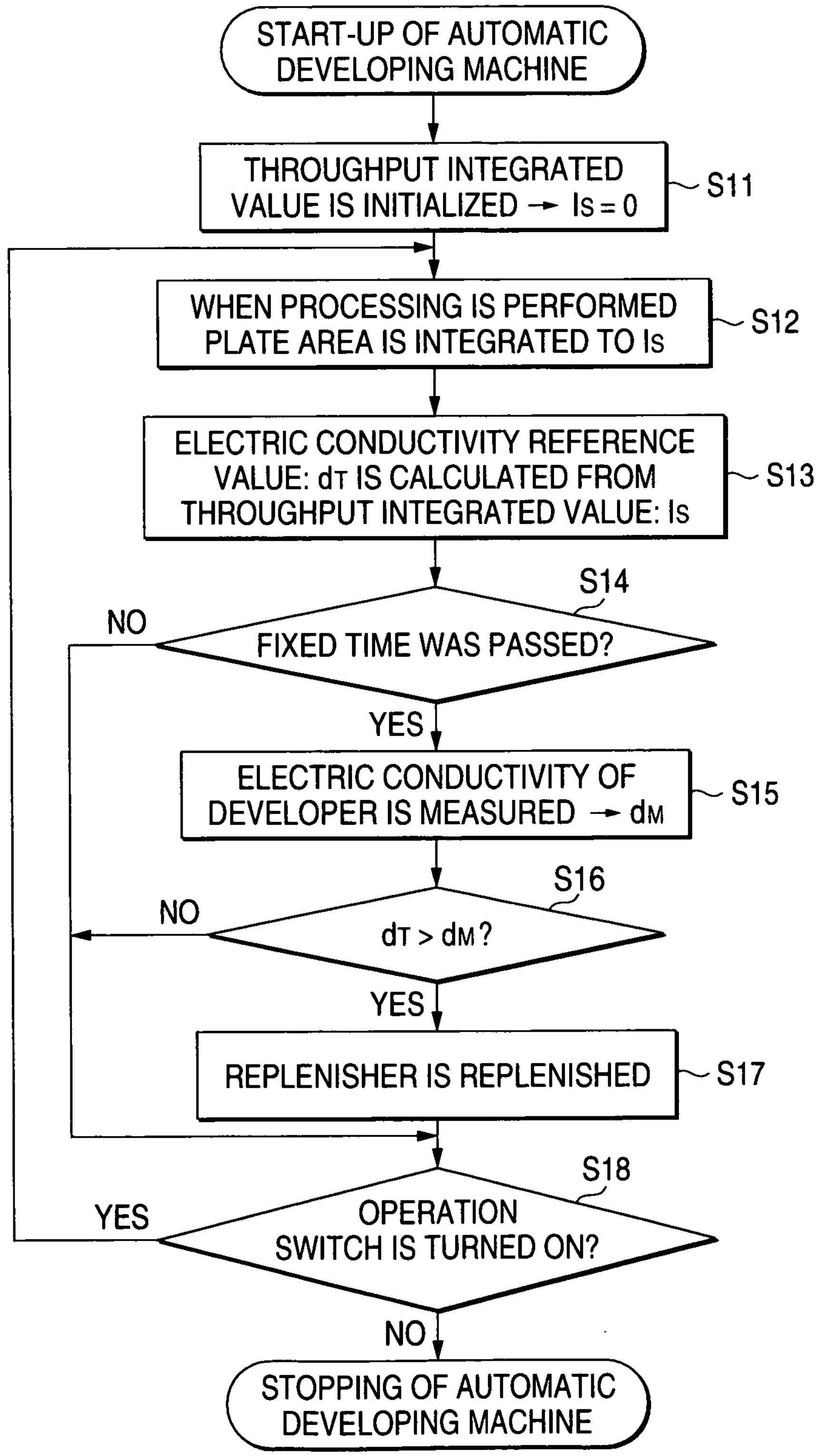
START-UP OF AUTOMATIC DEVELOPING MACHINE
THROUGHPUT INTEGRATED VALUE IS INITIALIZED → Is = 0
S11
WHEN PROCESSING IS PERFORMED PLATE AREA IS INTEGRATED TO Is
S12
ELECTRIC CONDUCTIVITY REFERENCE VALUE: dT IS CALCULATED FROM THROUGHPUT INTEGRATED VALUE: Is
S13
S14
NO
FIXED TIME WAS PASSED?
YES
ELECTRIC CONDUCTIVITY OF DEVELOPER IS MEASURED → dM
S15
S16
NO
dT > dM?
YES
REPLENISHER IS REPLENISHED
S17
S18
YES
OPERATION SWITCH IS TURNED ON?
NO
STOPPING OF AUTOMATIC DEVELOPING MACHINE

FIG. 4

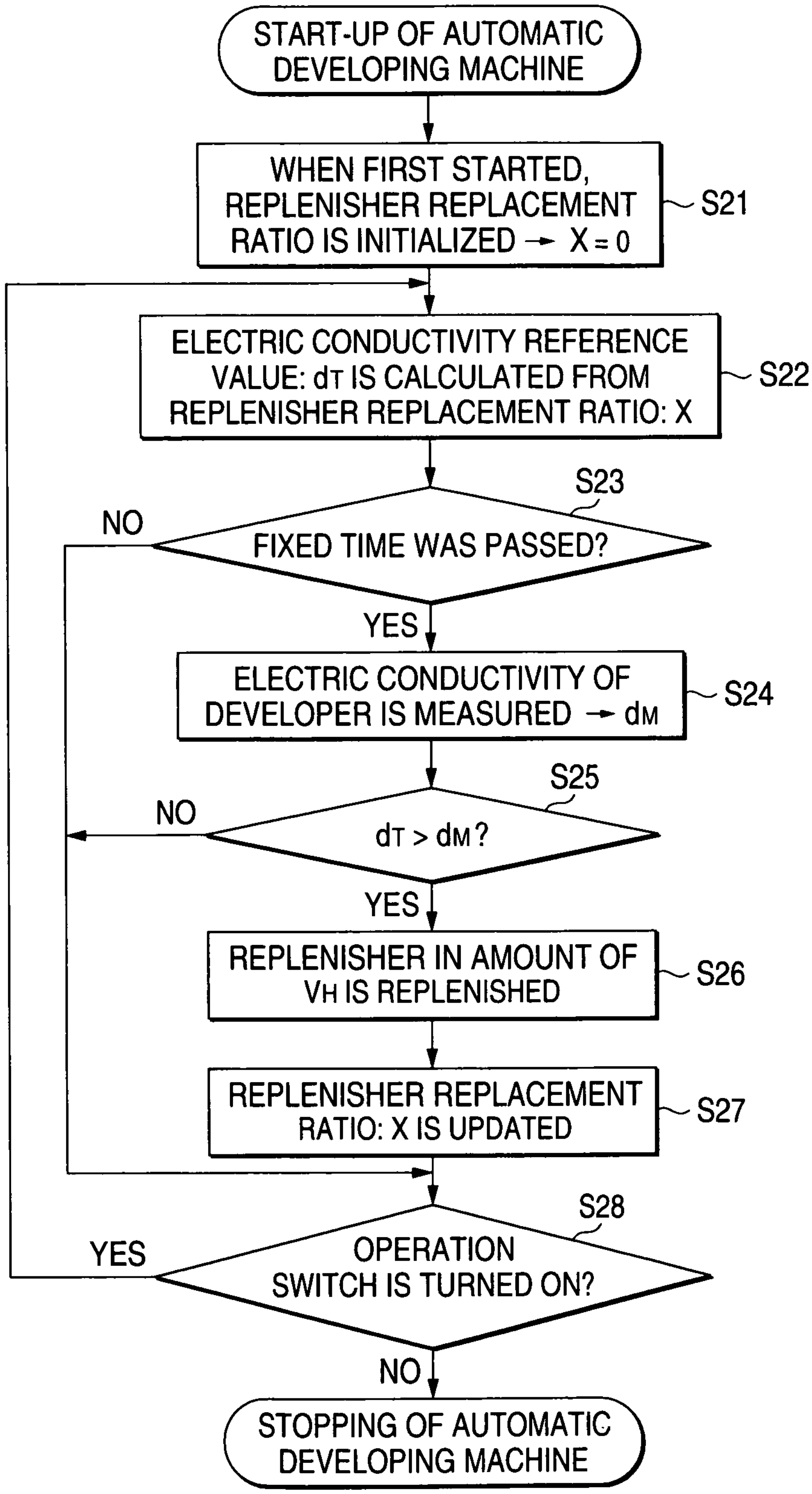
START-UP OF AUTOMATIC DEVELOPING MACHINE
WHEN FIRST STARTED, REPLENISHER REPLACEMENT RATIO IS INITIALIZED → X = 0
S21
ELECTRIC CONDUCTIVITY REFERENCE VALUE: dT IS CALCULATED FROM REPLENISHER REPLACEMENT RATIO: X
S22
S23
FIXED TIME WAS PASSED?
NO
YES
ELECTRIC CONDUCTIVITY OF DEVELOPER IS MEASURED → dM
S24
S25
dT > dM?
NO
YES
REPLENISHER IN AMOUNT OF VH IS REPLENISHED
S26
REPLENISHER REPLACEMENT RATIO: X IS UPDATED
S27
S28
OPERATION SWITCH IS TURNED ON?
YES
NO
STOPPING OF AUTOMATIC DEVELOPING MACHINE

FIG. 5

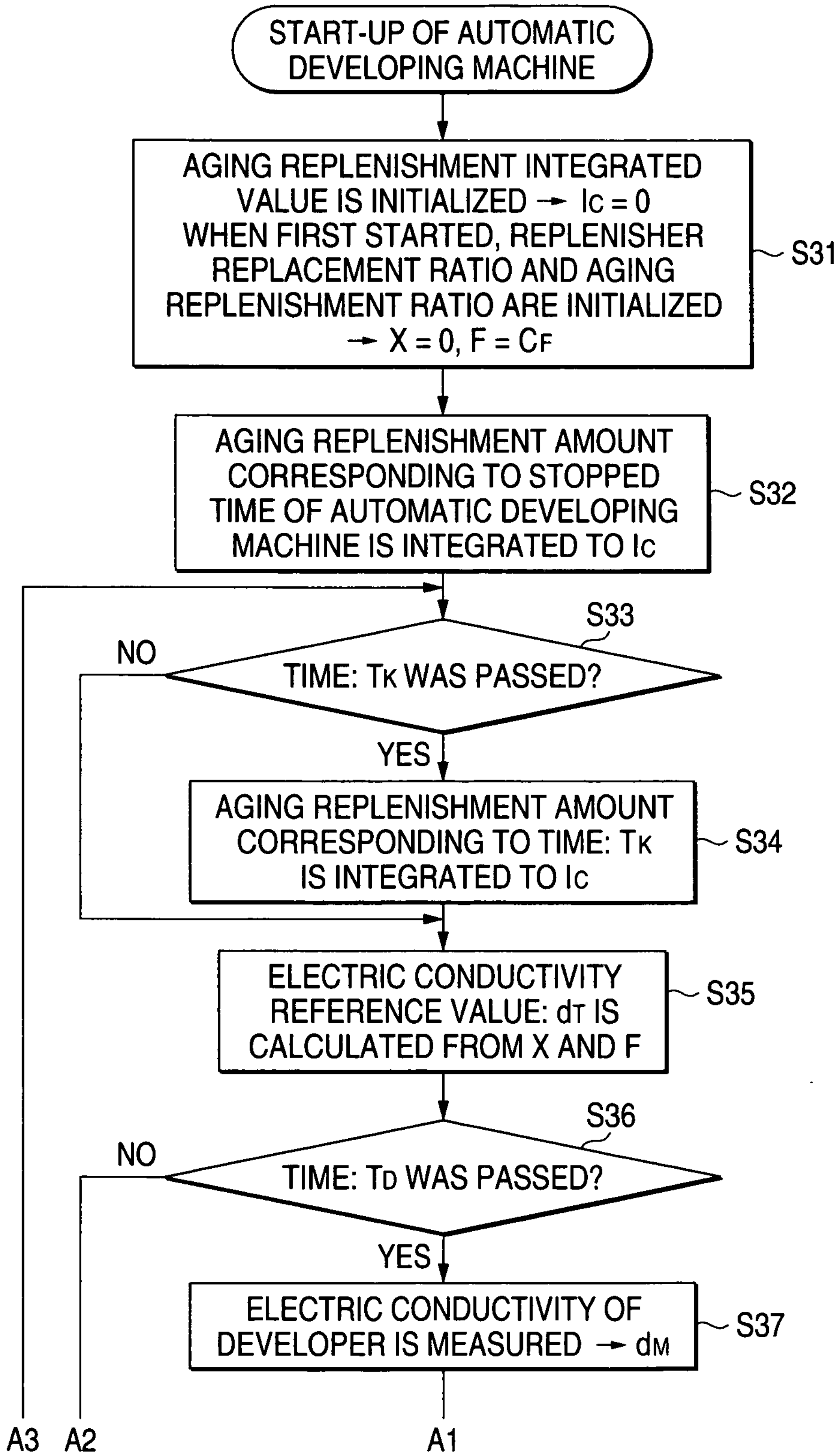
START-UP OF AUTOMATIC DEVELOPING MACHINE
AGING REPLENISHMENT INTEGRATED VALUE IS INITIALIZED → Ic = 0 WHEN FIRST STARTED, REPLENISHER REPLACEMENT RATIO AND AGING REPLENISHMENT RATIO ARE INITIALIZED → X = 0, F = CF
S31
AGING REPLENISHMENT AMOUNT CORRESPONDING TO STOPPED TIME OF AUTOMATIC DEVELOPING MACHINE IS INTEGRATED TO Ic
S32
S33
NO
TIME: TK WAS PASSED?
YES
AGING REPLENISHMENT AMOUNT CORRESPONDING TO TIME: TK IS INTEGRATED TO Ic
S34
ELECTRIC CONDUCTIVITY REFERENCE VALUE: dT IS CALCULATED FROM X AND F
S35
S36
NO
TIME: TD WAS PASSED?
YES
ELECTRIC CONDUCTIVITY OF DEVELOPER IS MEASURED → dM
S37
A3
A2
A1

FIG. 6

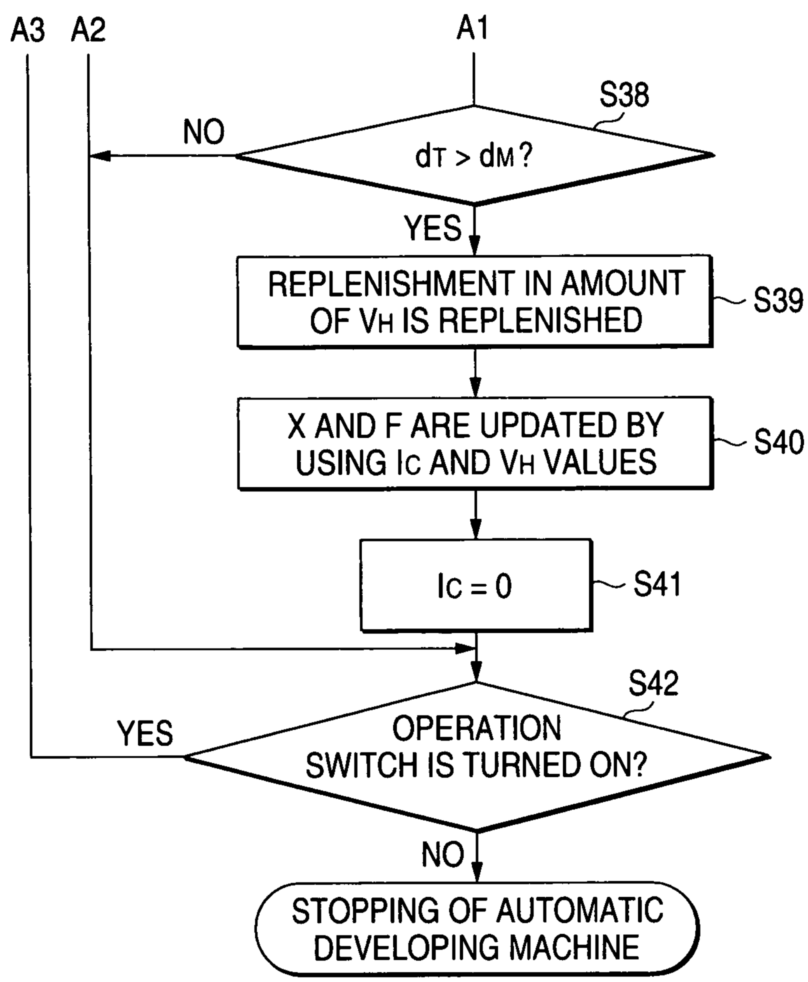
A3
A2
A1
S38
NO
dT > dM?
YES
REPLENISHMENT IN AMOUNT OF VH IS REPLENISHED
S39
X AND F ARE UPDATED BY USING IC AND VH VALUES
S40
IC = 0
S41
S42
YES
OPERATION SWITCH IS TURNED ON?
NO
STOPPING OF AUTOMATIC DEVELOPING MACHINE

*FIG. 7*

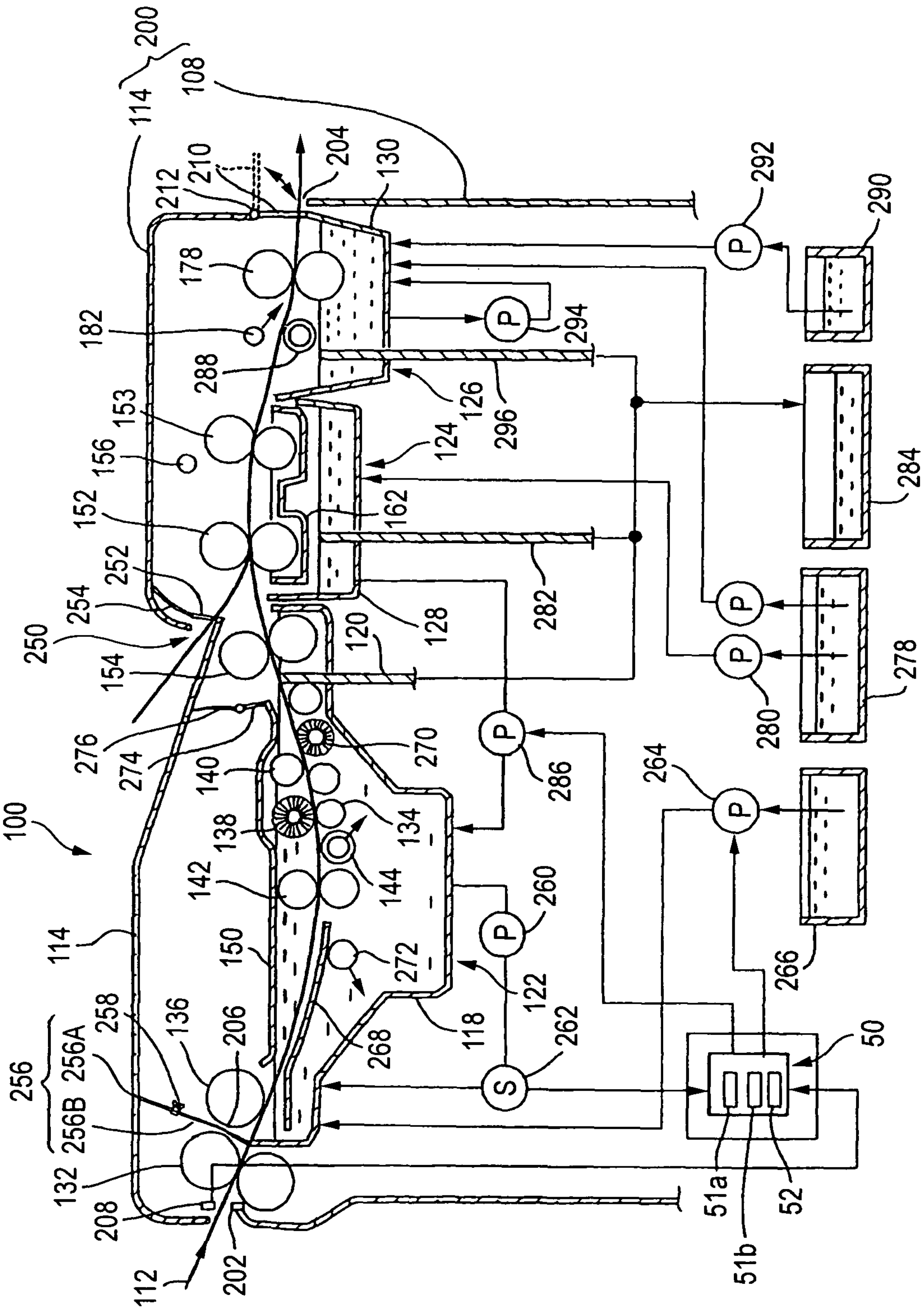
200
114
108
212
210
204
130
292
290
178
182
294
288
126
296
153
156
124
284
152
162
282
252
254
128
250
120
278
280
154
276
274
270
140
286
100
138
134
264
144
142
260
150
272
114
122
266
258
136
206
268
118
262
256
256A
256B
50
132
51a
51b
52
208
202
112
P
S

European Patent Office

# EUROPEAN SEARCH REPORT

Application Number
EP 05 00 7523

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | EP 1 334 823 A (FUJI PHOTO FILM CO., LTD) 13 August 2003 (2003-08-13) * page 52 * | 1 | G03F7/30 B41C1/10 |
| X | EP 1 122 610 A (FUJI PHOTO FILM CO., LTD) 8 August 2001 (2001-08-08) * claims 4,5; figure 2 * | 1,3,4 | |
| X | US 4 882 246 A (OHBA ET AL) 21 November 1989 (1989-11-21) * example 1 * | 1 | |
| X | US 5 716 743 A (STEIN ET AL) 10 February 1998 (1998-02-10) * column 10, line 40 - line 46; claim 1 * | 1,2 | |
| X | EP 1 037 116 A (FUJI PHOTO FILM CO., LTD) 20 September 2000 (2000-09-20) * paragraph [0068] - paragraph [0070]; example 1 * | 1 | |

TECHNICAL FIELDS SEARCHED (Int.Cl.7)

G03F
B41C

The present search report has been drawn up for all claims

| Place of search | Date of completion of the search | Examiner |
|---|---|---|
| The Hague | 3 August 2005 | Heywood, C |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

2

EPO FORM 1503 03.82 (P04C01)

# ANNEX TO THE EUROPEAN SEARCH REPORT ON EUROPEAN PATENT APPLICATION NO. EP 05 00 7523

This annex lists the patent family members relating to the patent documents cited in the above-mentioned European search report.
The members are as contained in the European Patent Office EDP file on
The European Patent Office is in no way liable for these particulars which are merely given for the purpose of information.

03-08-2005

| Patent document cited in search report | | Publication date | Patent family member(s) | | | Publication date |
|---|---|---|---|---|---|---|
| EP 1334823 | A | 13-08-2003 | JP | 2004118017 | A | 15-04-2004 |
| | | | JP | 2003302750 | A | 24-10-2003 |
| | | | JP | 2004212852 | A | 29-07-2004 |
| | | | EP | 1334823 | A2 | 13-08-2003 |
| | | | US | 2003207203 | A1 | 06-11-2003 |
| EP 1122610 | A | 08-08-2001 | CN | 1312490 | A | 12-09-2001 |
| | | | DE | 60111283 | D1 | 14-07-2005 |
| | | | EP | 1122610 | A2 | 08-08-2001 |
| | | | JP | 2001290249 | A | 19-10-2001 |
| | | | US | 6364544 | B1 | 02-04-2002 |
| US 4882246 | A | 21-11-1989 | JP | 1021451 | A | 24-01-1989 |
| | | | JP | 2516022 | B2 | 10-07-1996 |
| | | | DE | 3824334 | A1 | 26-01-1989 |
| | | | GB | 2208249 | A ,B | 15-03-1989 |
| US 5716743 | A | 10-02-1998 | DE | 4204691 | A1 | 02-09-1993 |
| | | | US | 5930547 | A | 27-07-1999 |
| | | | DE | 59308518 | D1 | 18-06-1998 |
| | | | DK | 556690 | T3 | 18-01-1999 |
| | | | EP | 0556690 | A1 | 25-08-1993 |
| | | | JP | 3303007 | B2 | 15-07-2002 |
| | | | JP | 6043661 | A | 18-02-1994 |
| EP 1037116 | A | 20-09-2000 | JP | 2000267296 | A | 29-09-2000 |
| | | | JP | 2000352826 | A | 19-12-2000 |
| | | | EP | 1037116 | A2 | 20-09-2000 |
| | | | US | 6315467 | B1 | 13-11-2001 |

EPO FORM P0459

For more details about this annex : see Official Journal of the European Patent Office, No. 12/82